(19) Europäisches Patentamt
European Patent Office
Office européen des brevets

(11) EP 1 486 521 A1

(12) **EUROPEAN PATENT APPLICATION**
published in accordance with Art. 158(3) EPC

(43) Date of publication:
**15.12.2004 Bulletin 2004/51**

(21) Application number: **03710324.9**

(22) Date of filing: **12.03.2003**

(51) Int Cl.[7]: **C08G 8/28**, C08F 290/02, C08F 8/00, C08G 59/16

(86) International application number:
**PCT/JP2003/002930**

(87) International publication number:
**WO 2003/078494 (25.09.2003 Gazette 2003/39)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **15.03.2002 JP 2002072751**
**18.03.2002 JP 2002074580**
**18.03.2002 JP 2002074684**

(71) Applicant: **Taiyo Ink Manufacturing Co. Ltd**
**Nerima-ku, Tokyo 176-8508 (JP)**

(72) Inventors:
- **KAMAYACHI, Yuichi,**
  **Taiyo Ink Manufacturing Co. Ltd**
  **Tokyo 176-8508 (JP)**
- **KOHIYAMA, Noboru,**
  **Taiyo Ink Manufacturing Co., Ltd**
  **Ranzanmachi, Hiki-gun, Saitama 355-02 (JP)**

(74) Representative:
**Luderschmidt, Schüler & Partner GbR**
**Patentanwälte,**
**John-F.-Kennedy-Strasse 4**
**65189 Wiesbaden (DE)**

# (54) CURABLE RESINS AND CURABLE RESIN COMPOSITIONS CONTAINING THE SAME

(57) There is provided a curable resin having an unsaturated group and a carboxyl group at the terminals of its side chains, such as a curable resin obtained by reacting an unsaturated group-containing monocarboxylic acid (d) with a reaction product (c) of a compound having three or more phenolic hydroxyl groups in its molecule (a) and an alkylene oxide (b) and further reacting a polybasic acid anhydride (f) with the resultant reaction product (e). By compounding such a curable resin with a photopolymerization initiator, a photosensitive (meth) acrylate compound, an epoxy compound, a diluent solvent, another curable resin which has a carboxyl group and an unsaturated group in its molecule and which is in the state of solid at room temperature, a flame-retardant, etc., there is obtained a photocurable and thermosetting resin composition which is useful for the formation of a solder resist of a printed circuit board, an interlaminar insulating layer of a multi-layer circuit board, or the like.

EP 1 486 521 A1

## Description

Technical Field

This invention relates to a curable resin having an unsaturated group and a carboxyl group at the terminals of its side chains and a curable resin composition containing the same, more particularly to a curable resin capable of producing a cured film excelling in resistance to soldering heat and resistance to PCT (pressure cooker test) and also excelling in adhesiveness, resistance to chemicals, resistance to electroless gold plating, electrical insulating properties, resistance to moisture absorption, etc. and a curable resin composition containing the same.

This invention further relates to a photocurable and thermosetting resin composition, particularly a flame-retardant, photocurable and thermosetting resin composition, which is suitable for use as a solder resist of a printed circuit board and the like, excels in the tack-free dryness after preliminary drying and developing properties, and can give a cured product excelling in adhesiveness, resistance to soldering heat, resistance to chemicals, resistance to moisture absorption, resistance to electroless gold plating, PCT resistance, electrical insulating properties, flame retardancy, etc.

Background Art

At present, as a photocurable and thermosetting resin composition to be used as a resist of a printed circuit board and the like, with due respect to the problem of environmental safety, an alkali developing type photocurable and thermosetting resin composition which implements development with a dilute aqueous alkaline solution as a developer has come to play the leading role.

As such an alkali developing type photocurable and thermosetting resin composition using a dilute aqueous alkaline solution, there are, for example, a resist ink composition comprising a curable resin obtained by adding an acid anhydride to a reaction product of a novolak type epoxy compound with an unsaturated group-containing monocarboxylic acid, a photopolymerization initiator, a photopolymerizable monomer, and an epoxy compound (published Japanese Patent Application, JP 61-243869A), a resist ink composition characterized by comprising a curable resin which is obtained by reacting an epihalohydrin to an alcoholic secondary hydroxyl group of a reaction product of an aromatic epoxy resin having two glycidyl groups in its molecule and an aromatic alcoholic resin having two phenolic hydroxyl groups in its molecule and subsequently adding an unsaturated group-containing monocarboxylic acid and then an acid anhydride to the resultant reaction product (JP 5-32746A), and the like.

Heretofore, a composition of the curable resin originating from a cresol novolak type epoxy resin as a start material (JP 61-243869A) is widely used in many fields of electronic material, such as a solder resist to be used in the manufacture of a printed circuit board and a permanent mask to be used in the manufacture of a tape carrier package, because its cured film excels in such properties as resistance to soldering heat, resistance to chemicals, and electrical insulating properties.

However, the recent advances of the electric industry and semiconductor industry require more improvement in the characteristics such as, for example, heat resistance and PCT resistance. In order to satisfy such demands, various curable resins are developed.

Among these resins, as a curable resin composition having outstanding heat resistance and PCT resistance, various compositions containing an alkali-soluble curable resin such as, for example, a composition containing a curable resin obtained by reacting tetrahydrophthalic anhydride with a reaction product of a cresol novolak type epoxy resin, dimethylol propionic acid, and acrylic acid (JP 6-324490A), a composition containing a curable resin obtained by reacting tetrahydrophthalic anhydride with a reaction product of a cresol novolak type epoxy resin, acrylic acid, and p-hydroxyphenetyl alcohol (JP 11-288091A), a composition containing a curable resin obtained by reacting (meth) acrylic acid with a bisphenol type epoxy resin having side chains of which hydroxyl groups are partially epoxidized and then reacting a polybasic acid anhydride with the resultant reaction product (JP 9-54434A and JP 2001-13684A), etc. are proposed.

However, these curable resin compositions are also still insufficient to obtain a cured film satisfying both the heat resistance and PCT resistance.

As mentioned above, some composition systems are heretofore proposed as a curable resin composition and currently used in large quantities in the practical manufacture of printed circuit boards. However, in view of high densification of the printed circuit board to cope with the recent trend of electronic devices toward decreasing weight and size, the desirability of producing a cured film with good workability in the process in addition to its high performance has been finding growing recognition.

That is, in the printed circuit boards having the solder resist formed by the use of a conventional curable resin composition, however, the PCT resistance which is the long-term reliability test was inferior, which resulted in exfoliation of a resist in the PCT test. Such a problem in long-term reliability is undesirable not only in the case of the resist on a

printed circuit board but also in the products for other uses, such as interlaminar insulating layers of multi-layer circuit boards like a build-up board. Moreover, since an automatic exposure apparatus has come into wide use in view of improving the workability, another matter which comes into question is the tack-free dryness after preliminary drying.

Further, since the cured films of the curable resin compositions mentioned above are combustible, their use in the applications which strongly require flame retardancy is restricted from the viewpoint of safety. As a method for imparting the flame retardancy to a curable resin composition, generally the incorporation of a fame-retardant into the composition is well known. As long as such a composition is used, however, the impairment of heat resistance, resistance to moisture absorption, or other property comes into question. Accordingly, this method is hardly possible to put into use at present.

The present invention has been made in view of the problems mentioned above and has an object to provide an alkali-soluble curable resin capable of forming a cured product which exhibits the well-balanced heat resistance and PCT resistance at a high level and also excels in various properties such as adhesiveness to a substrate, hardness, resistance to chemicals, and resistance to moisture absorption.

Further, another object of the present invention is to provide a curable resin composition, particularly a photocurable and thermosetting resin composition, which is capable of forming an excellent cured film fully satisfying such properties as resistance to soldering heat, PCT resistance, adhesiveness to a substrate, resistance to chemicals, resistance to electroless gold plating, electrical insulating properties, and resistance to moisture absorption required of a solder resist of a printed circuit board and which exhibits good tack-free dryness and developing properties.

A further object of the present invention is to provide a photocurable and thermosetting resin composition which also excels in flame retardancy, without impairing such excellent properties as resistance to soldering heat, resistance to chemicals, resistance to moisture absorption, adhesiveness, PCT resistance, resistance to electroless gold plating, and electrical insulating properties mentioned above.

Disclosure of the Invention

To accomplish the objects mentioned above, the present invention provides a curable resin having an unsaturated group and a carboxyl group at the terminals of its side chains. One embodiment thereof is a curable resin obtained by reacting an unsaturated group-containing monocarboxylic acid (d) with a reaction product (c) of a compound having three or more phenolic hydroxyl groups in its molecule (a) and an alkylene oxide (b) and further reacting a polybasic acid anhydride (f) with the resultant reaction product (e).

Another embodiment of the curable resin according to the present invention is the curable resin having the groups represented by the following formulas (I) and (II) in its side chains.

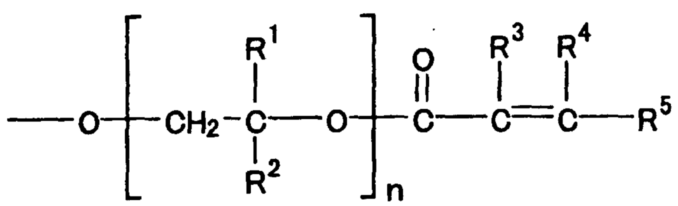

··· (I)

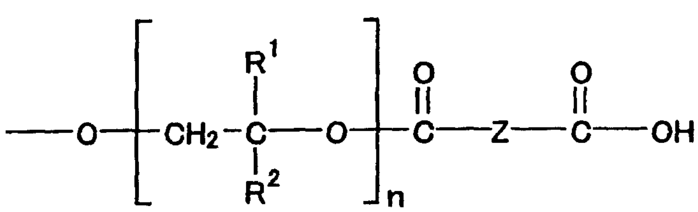

··· (II)

wherein $R^1$ and $R^2$ independently represent a hydrogen atom, a methyl group, or an ethyl group, $R^3$, $R^4$, and $R^5$ independently represent a hydrogen atom, an alkyl group having 1 to 6 carbon atoms, an aryl group, an aralkyl group, a cyano group, a fluorine atom, or a furyl group, Z represents a polybasic acid anhydride residue, and n is a numerical value of 0.5 to 10.

In accordance with a more concrete preferred embodiment, the compound having three or more phenolic

hydroxyl groups in its molecule (a) mentioned above is a condensation product of a phenolic compound represented by the following general formula (III) and an aromatic aldehyde compound having a phenolic hydroxyl group, the unsaturated group-containing monocarboxylic acid (d) is acrylic acid and/or methacrylic acid, and the polybasic acid anhydride (f) is an alicyclic dibasic acid anhydride.

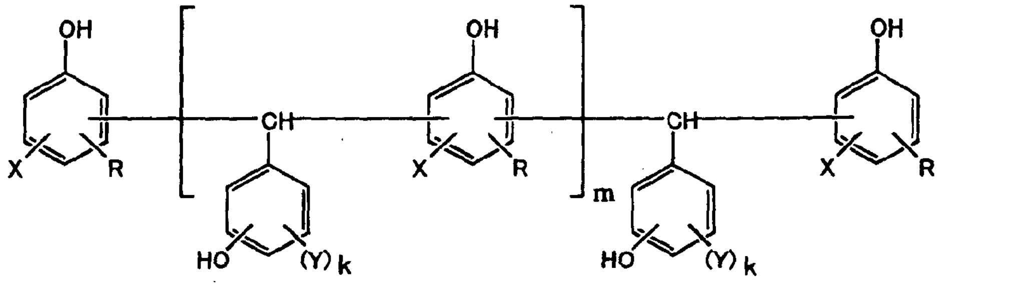

··· (III)

wherein R represents a hydrogen atom or an alkyl group having 1 to 18 carbon atoms, X represents a hydrogen atom or a halogen atom, Y represents an alkyl group or an alkoxy group each having 1 to 18 carbon atoms, k is an integer of 0, 1, or 2, and m is an integer of 0 or more.

Since the curable resin of the present invention has an unsaturated group and a carboxyl group at the terminals of its side chains, it exhibits excellent reactivity. Further, since the curable resin contains a hydrophilic and alcoholic hydroxyl group which exhibits low reactivity in a small amount or contains no such group, it allows the formation of a cured product having well-balanced heat resistance and PCT resistance at a high level and excelling in various properties such as adhesiveness to a substrate, hardness, resistance to chemicals, and resistance to moisture absorption. Accordingly, a curable resin composition comprising this curable resin together with a photopolymerization initiator, a photosensitive (meth) acrylate compound, an epoxy compound, a diluent solvent, etc. exhibits excellent alkali-developing properties and gives a cured product excelling in such properties as resistance to soldering heat, PCT resistance, adhesiveness, resistance to chemicals, resistance to electroless gold plating, electrical insulating properties, and resistance to moisture absorption.

Therefore, in accordance with another aspect of the present invention, there is provided a curable resin composition containing the curable resin mentioned above.

In accordance with a preferred embodiment of the present invention, there is provided a photocurable and thermosetting resin composition characterized by comprising (A) the curable resin mentioned above, i.e. the curable resin obtained by reacting an unsaturated group-containing monocarboxylic acid (d) with a reaction product (c) of a compound having three or more phenolic hydroxyl groups in its molecule (a) and an alkylene oxide (b) and further reacting a polybasic acid anhydride (f) with the resultant reaction product (e), or the curable resin having the groups represented by the aforementioned formulas (I) and (II) in its side chains, (B) a photopolymerization initiator, (C) a photosensitive (meth)acrylate compound, (D) an epoxy compound, and (E) a diluent solvent.

In accordance with more concrete and preferred embodiment of the present invention, there is provided a photocurable and thermosetting resin composition characterized by further comprising (F) a curable resin which has a carboxyl group and an unsaturated group in its molecule and which is in the state of solid at room temperature besides the aforementioned components.

In accordance with a more preferred embodiment, it is preferable that the photocurable and thermosetting resin composition should contain a curing catalyst (G).

In accordance with another more concrete and preferred embodiment of the present invention, there is provided a photocurable and thermosetting resin composition characterized by further comprising a flame-retardant (H). As the flame-retardant (H), at least one member selected from the group consisting of a halogenated epoxy resin, a halogenated aromatic compound, a halogenated alicyclic compound, a phosphate-based flame-retardant, and an antimony oxide-based flame-retardant is advantageously used.

Brief Description of Drawing

Fig. 1 shows the infrared absorption spectrum of the curable resin obtained in Synthetic Example 1.

Best Mode for Carrying Out the Invention

The present inventors, after pursuing a diligent study to solve the problems mentioned above, have found that a composition obtained by the use of a curable resin which is obtained by reacting an unsaturated group-containing

monocarboxylic acid (d) with a reaction product (c) of a compound having three or more phenolic hydroxyl groups in its molecule (a) and an alkylene oxide (b) and further reacting a polybasic acid anhydride (f) with the resultant reaction product (e) (particularly, a curable resin obtained by the use of acrylic acid and/or methacrylic acid as the unsaturated group-containing monocarboxylic acid and an alicyclic dibasic acid anhydride as the polybasic acid anhydride) or a curable resin having the groups represented by the aforementioned formulas (I) and (II) in its side chains allows the production of a cured product excelling in such properties as resistance to soldering heat, PCT resistance, adhesiveness to various substrates, resistance to chemicals, resistance to electroless gold plating, electrical insulating properties, and resistance to moisture absorption in combination. As a result, the present invention has been perfected.

Specifically, the curable resin of the present invention excels in flexibility and elongation owing to the chain extension by an addition reaction of the alkylene oxide (b) to the compound having three or more phenolic hydroxyl groups in its molecule (a). Further, since the subsequent addition of the unsaturated group-containing monocarbxylic acid (d) and the addition of the polybasic acid anhydride (f) take place at end hydroxyl groups caused by the addition reaction of the alkylene oxide, an unsaturated group and a carboxylic group are not present in the same side chain and respectively located at the terminals of the side chains. Therefore, the resin excels in reactivity and exhibits excellent alkali-developability owing to the presence of the end carboxyl groups away from the main chain. Furthermore, since the resin does not contain a hydrophilic and alcoholic hydroxyl group of low reactivity or contains such a group in a small amount, unlike the conventionally used resin of epoxy acrylate modified with an acid anhydride, it excels in resistance to moisture absorption.

Accordingly, a curable resin composition containing the aforementioned curable resin together with an organic solvent, a photopolymerization initiator, a photosensitive (meth)acrylate compound, an epoxy resin, etc. exhibits excellent alkali developing properties, photocuring properties, and thermosetting properties. When its coating film is selectively exposed to light, developed, and finally cured, there is obtained a cured product excelling in resistance to soldering heat, PCT resistance, adhesiveness, resistance to chemicals, resistance to electroless gold plating, electrical insulating properties, resistance to moisture absorption, etc.

Since a composition containing the curable resin having no such alcoholic hydroxyl group will exhibit inferior tack-free dryness, however, it is preferable that this resin should be used in combination with other resin from the viewpoint of workability. In order to acquire good tack-free dryness without impairing various properties, the other resin to be used in combination should be just a curable resin which has a carboxyl group and an unsaturated group in its molecule and which is in the state of solid at room temperature.

Accordingly, the photocurable and thermosetting resin composition of the present invention containing these two kinds of curable resins together with an organic solvent, a photopolymerization initiator, a photosensitive (meth) acrylate compound, an epoxy compound, etc. exhibits excellent tack-free dryness and alkali developing properties. And also, when its coating film is selectively exposed to light, developed, and finally cured, there is obtained a cured film excelling in adhesiveness, resistance to soldering heat, resistance to chemicals, resistance to electroless gold plating, PCT resistance, electrical insulating properties, etc.

When a flame-retardant is incorporated into the curable resin composition mentioned above, excellent flame retardancy may be imparted to the composition. Even if the flame-retardant is incorporated into the composition, there is no possibility of impairing the film properties such as resistance to moisture absorption and heat resistance.

Now, the curable resin of the present invention and the curable resin composition containing it will be described in detail below.

First, the curable resin (A) of the present invention is, as described above, the curable resin having the groups represented by the above-mentioned formulas (I) and (II) in its side chains or the curable resin obtained by reacting an unsaturated group-containing monocarboxylic acid (d) with a reaction product (c) of a compound having three or more phenolic hydroxyl groups in its molecule (hereinafter referred to briefly as "a polyfunctional phenolic hydroxyl group-containing compound") (a) and an alkylene oxide (b) and further reacting a polybasic acid anhydride (f) with the resultant reaction product (e). Each reaction is easily carried out in a solvent by the use of a catalyst to be described hereinbelow.

These reactions will be described in detail below. First, the reaction between the polyfunctional phenolic hydroxyl group-containing compound (a) and the alkylene oxide (b) will proceed as follows, for example, when poly-p-hydroxystyrene and propylene oxide are used. In the following reaction formulas, formula (1) schematically represents the case that the propylene oxide (b) is subjected to the reaction at the ratio of less than one equivalent of its epoxy group, formula (2) schematically represents the case that the propylene oxide (b) is subjected to the reaction at the ratio of one equivalent of its epoxy group, and formula (3) schematically represents the case that the propylene oxide (b) is subjected to the reaction at the ratio of more than one equivalent of its epoxy group, respectively based on one equivalent of the phenolic hydroxyl group of the polyfunctional phenolic hydroxyl group-containing compound (a).

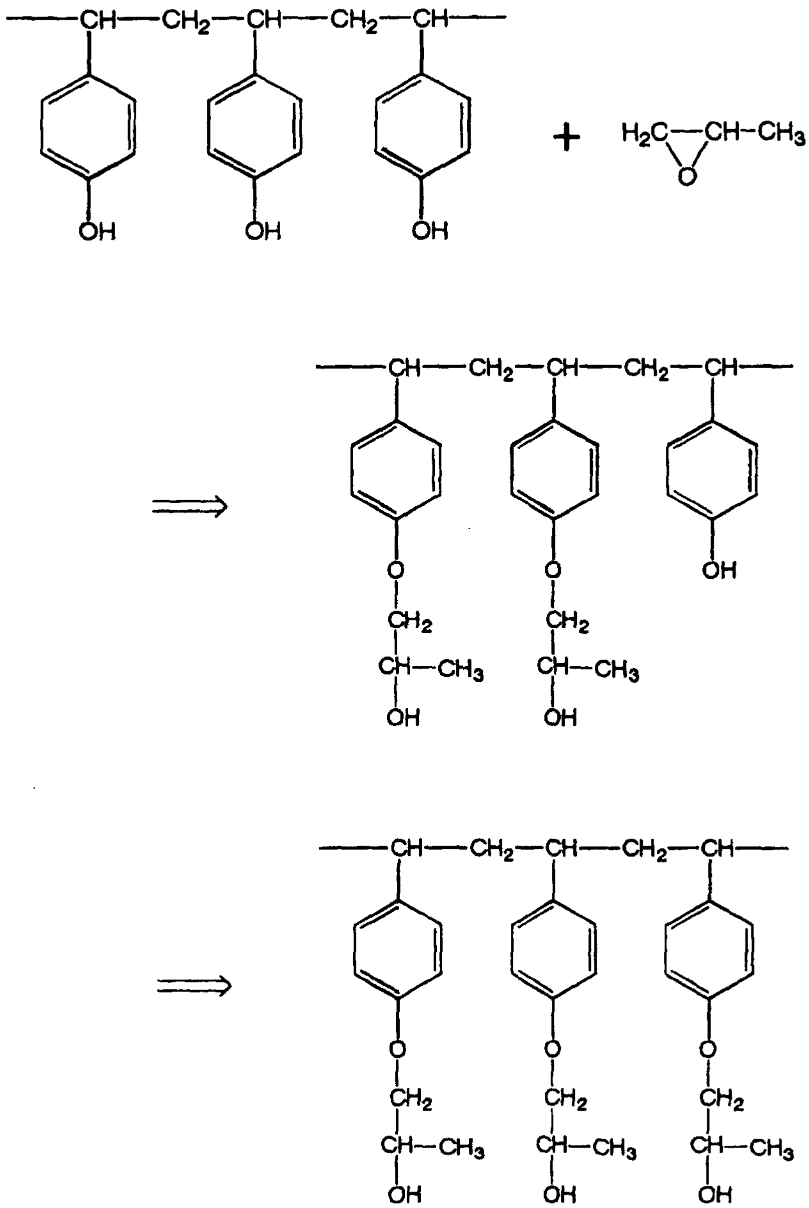

......(1)

......(2)

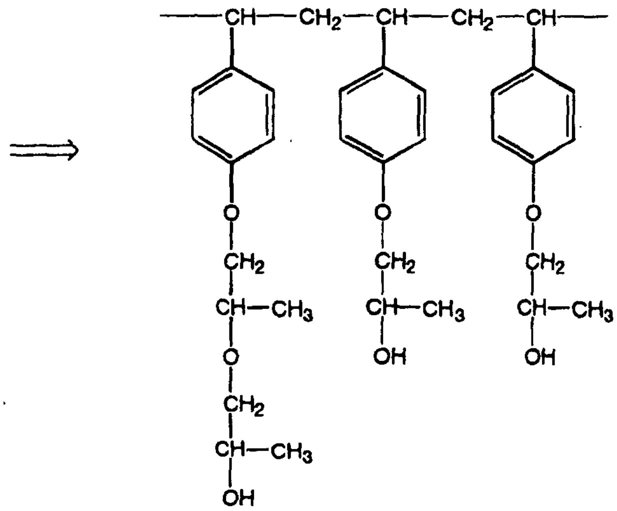

……(3)

Next, the reaction of the unsaturated group-containing monocarboxylic acid (d) to the reaction product (c) of formula (1), (2), or (3) mentioned above proceeds as follows, for example, when acrylic acid is used. That is, when the addition of the propylene oxide (b) to the polyfunctional phenolic hydroxyl group-containing compound (a) takes place partially as shown in the above-mentioned formula (1), the addition of the unsaturated group-containing monocarboxylic acid (d) to the resultant addition reaction product (c) will take place predominantly at the hydroxyl group possessed by the propylene oxide (b) added to the above-mentioned polyfunctional phenolic hydroxyl group-containing compound (a) as shown in the following formula (4). The addition of the unsaturated group-containing monocarboxylic acid (d) to the reaction product (c) of the formula (2) will take place as shown in the following formula (5). Further, the addition of the unsaturated group-containing monocarboxylic acid (d) to the reaction product (c) of the formula (3) will take place as shown in the following formula (6).

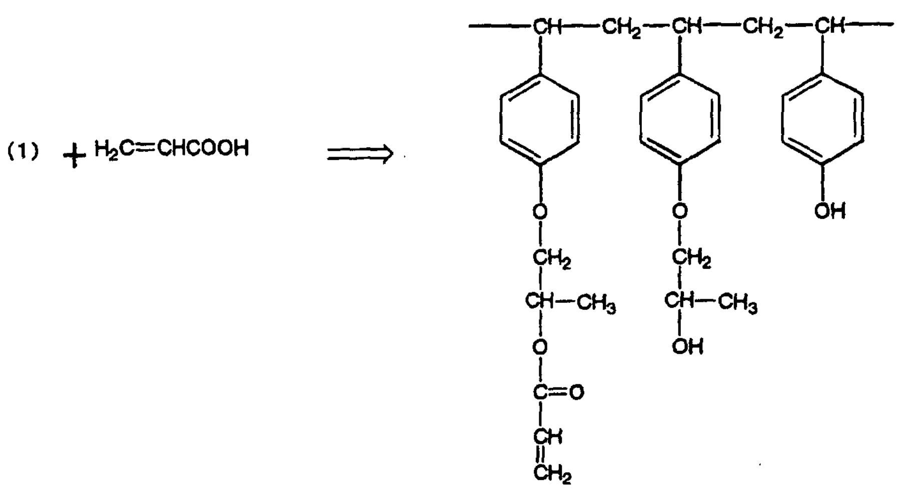

……(4)

(2) + $H_2C=CHCOOH$ 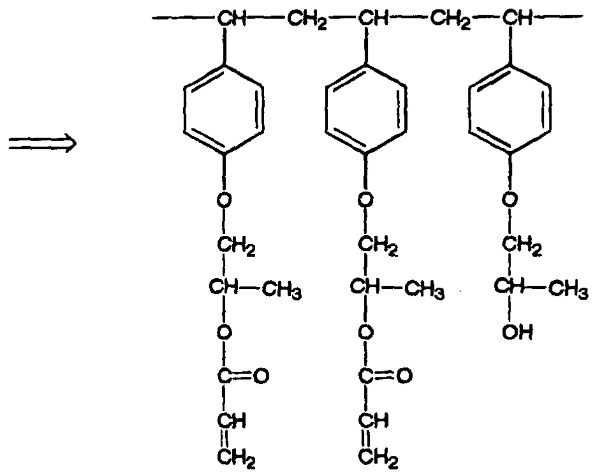 ......(5)

(3) + $H_2C=CHCOOH$ 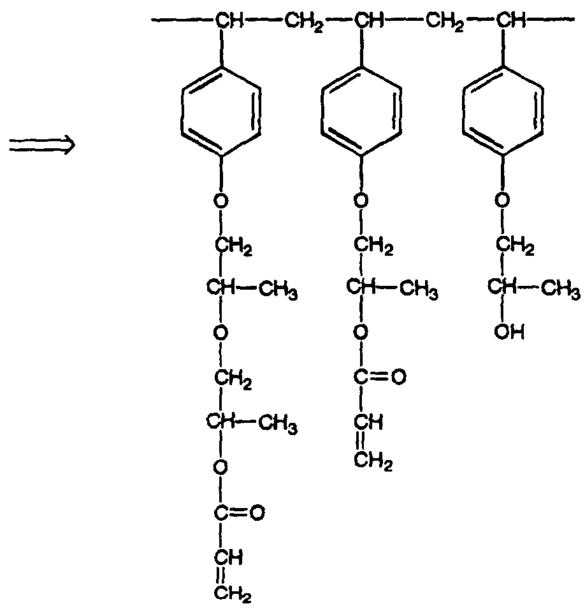 ......(6)

Finally, the reaction of the polybasic acid anhydride (f) to the reaction product (e) of formula (4), (5), or (6) mentioned above proceeds as follows, for example, when tetrahydrophthalic anhydride is used. Since the addition of the polybasic acid anhydride will take place predominantly at the alcoholic hydroxyl group, the reaction will proceed as shown in the following formula (7), (8), or (9). However, the reaction will take place in various variations depending on the addition ratio of the polybasic acid anhydride.

(4)

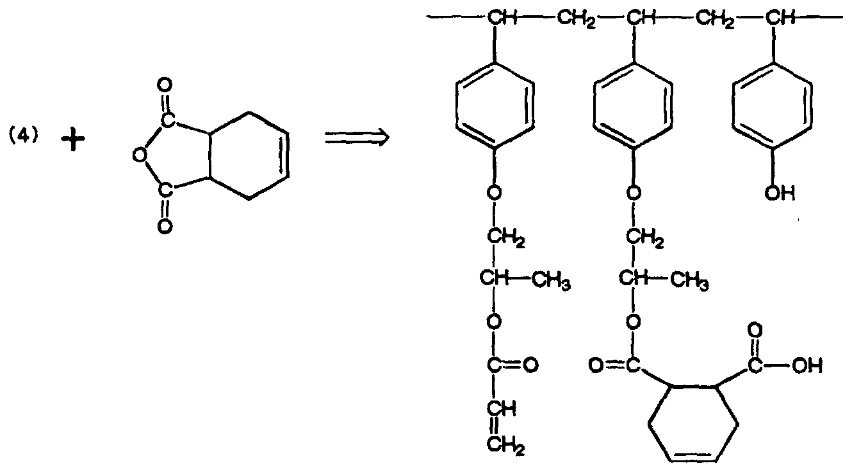

……(7)

(5)

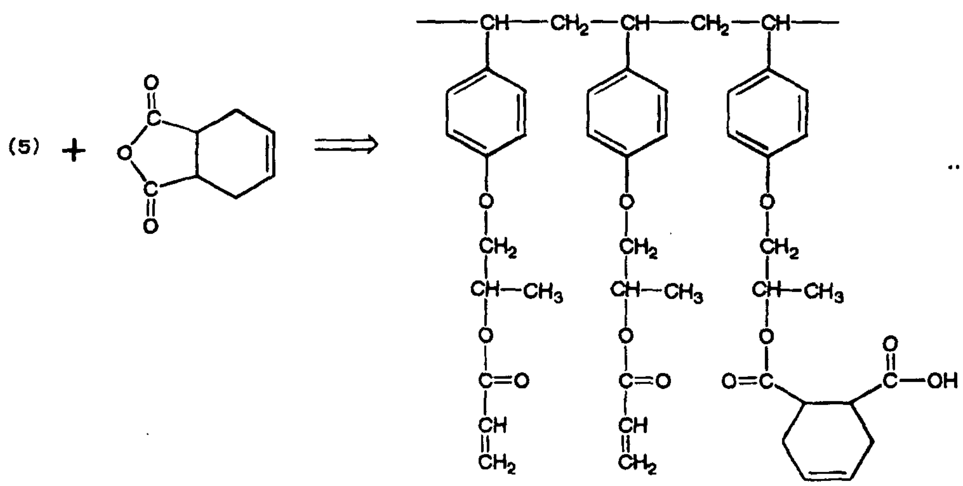

……(8)

(6) 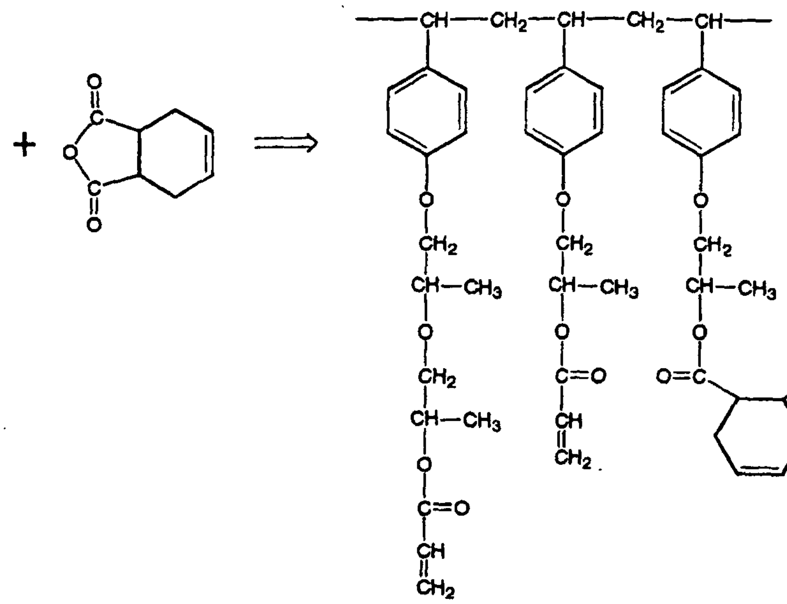 ······(9)

As the polyfunctional phenolic hydroxyl group-containing compound (a), a condensation product of a phenolic compound and an aromatic aldehyde compound having a phenolic hydroxyl group, a condensation product of an aldehyde compound and poly-p-hydroxystyrene or 1,2-, 1,3-, 1,4-, 1,5-, 1,6-, 2,3-, 2,6- or 2,7-dihydroxynaphthalene, a condensation product of a mononaphthol, dihydroxynaphthalene mentioned above, and an aldehyde compound, a condensation product of mono- or di- hydroxynaphthalene and a xylylene glycol compound, an addition product of mono- or di-hydroxynaphthalene and a diene compound, etc. may be cited, but it is not restricted to these compounds.

The polyfunctional phenolic hydroxyl group-containing compound mentioned above includes those having a phenolic hydroxyl group-containing aromatic ring or a hydrocarbon skeleton bonded to the phenolic hydroxyl group-containing aromatic ring, each containing a functional group which contains a halogen atom, oxygen, nitrogen, sulfur, etc., for example, a halogen group, an ether group, an ester group, a carbonyl group, a hydroxyl group, an aldehyde group, an amino group, an amide group, a nitrile group, a nitro group, a thiol group, a thioether group, and a heteroaromatic group such as a pyridyl group and an imidazole group.

Among other polyfunctional phenolic hydroxyl group-containing compounds enumerated above, the condensation product of a phenolic compound represented by the following general formula (III) and an aromatic aldehyde compound having a phenolic hydroxyl group proves to be desirable.

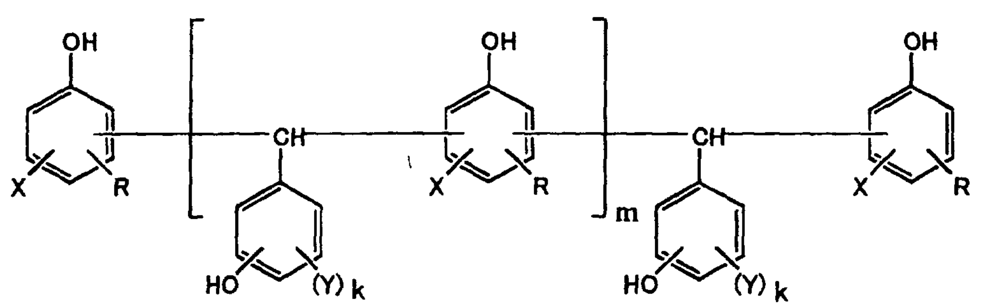 ··· (III)

wherein R, X, Y, k and m have the same meanings as mentioned above.

As the phenolic compound, the compounds represented by the following general formula (IV), for example, phenol, o-cresol, m-cresol, p-cresol, o-bromophenol, m-bromophenol, p-bromophenol, ethyl phenol, propyl phenol, butyl phenol, hexyl phenol, octyl phenol, nonyl phenol, etc. may be cited. Further, phenyl phenol, cumyl phenol, etc. may be used.

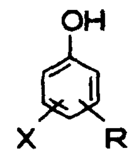

···(IV)

wherein R represents a hydrogen atom or an alkyl group having 1 to 18 carbon atoms, and X represents a hydrogen atom or a halogen atom.

As the aromatic aldehyde compound having a phenolic hydroxyl group, the compounds represented by the following general formula (V), for example, hydroxybenzaldehyde, methoxy hydroxybenzaldehyde, dimethoxy hydroxybenzaldehyde, salicylaldehyde, etc. may be cited.

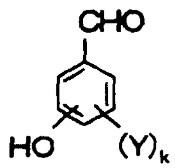

···(V)

wherein Y represents an alkyl group or an alkoxy group each having 1 to 18 carbon atoms, and k is an integer of 0, 1, or 2.

The condensation product of the phenolic compound and the aromatic aldehyde compound having a phenolic hydroxyl group mentioned above is obtained by the reaction thereof at the ratio of 0.1 to 3.0 mols, preferably 0.3 to 1.5 mols of the latter to one mol of the former in the presence of an acidic catalyst (that is usually used as a catalyst for the production of a novolak, such as mineral acids like hydrochloric acid and sulfuric acid, organic acids like oxalic acid and toluenesulfonic acid, and other organic acid salts) at a temperature in the range of 80 to 250°C, preferably 100 to 180°C for 1 to 6 hours.

The ratio of addition of the alkylene oxide (b) to the polyfunctional phenolic hydroxyl group-containing compound (a) mentioned above is preferred to be in the range of 0.5 to 10.0 mols, more preferably 1.0 to 6.0 mols per one equivalent of a phenolic hydroxyl group of the polyfunctional phenolic hydroxyl group-containing compound (a) mentioned above. If this ratio is less than 0.5 mol or more than 10.0 mols, the resultant carboxyl group-containing curable resin (A) will suffer from an undesirable decline in photocuring properties and thermosetting properties. Further, when a flame-retardant (H) is added to the curable resin composition, the composition will suffer from an undesirable decline in heat resistance and resistance to moisture absorption.

The addition reaction of the alkylene oxide (b) to the polyfunctional phenolic hydroxyl group-containing compound (a) is carried out in the presence of, for example, an alkali metal compound such as sodium hydroxide and potassium hydroxide, or a quaternary basic salt compound such as trimethylbenzyl ammonium hydroxide, tetramethylammonium hydroxide, and tetraetylammonium hydroxide, or a mixture of the alkali metal compound and the quaternary basic salt compound, by the use of an organic solvent such as ketones like methyl ethyl ketone, cyclohexanone, and methylisobutyl ketone, and aromatic hydrocarbons like toluene, xylene, and tetramethyl benzene, or a mixed solvent of these compounds, at a temperature in the range of 80 to 180°C under a pressure in the range of normal pressure to 10 kg/$cm^2$.

As the alkylene oxide (b), ethylene oxide, propylene oxide, butylene oxide, isobutylene oxide, trimethylene oxide, tetrahydrofuran, tetrahydropyran, etc. may be cited. Among other alkylene oxides enumerated above, ethylene oxide, propylene oxide, butylene oxide, and isobutylene oxide prove to be particularly desirable from the viewpoint of reactivity.

The reaction temperature of the esterification reaction of the reaction product (c) of the polyfunctional phenolic hydroxyl group-containing compound (a) and the alkylene oxide (b) with the unsaturated group-containing monocarboxylic acid (d) is preferred to be in the approximate range of 50 to 150°C. The reaction may proceed under reduced pressure, under normal pressure, and under pressure as well. In this esterification reaction, the amount of the unsaturated group-containing monocarboxylic acid (d) is preferred to be in such an addition proportion that the double bond equivalent of the produced curable resin of the present invention falls in the range of 300 to 700. As a reaction solvent, an aromatic hydrocarbon such as toluene, xylene, and tetramethyl benzene may be advantageously used. These solvents may be used either singly or in the form of a mixture of two or more members. As a esterification catalyst, sulfuric acid, hydrochloric acid, phosphoric acid, boron trifluoride, methanesulfonic acid, benzenesulfonic acid, p-toluenesulfonic acid, cation exchange resins, etc. may be suitably used. The esterification reaction is preferred to be carried out in the presence of a polymerization inhibitor. As the polymerization inhibitor, hydroquinone, methyl hydroquinone, hydroquinone monomethyl ether, catechol, pyrogallol, etc. may be advantageously used.

As typical examples of the unsaturated group-containing monocarboxylic acids (d) mentioned above, acrylic acid, methacrylic acid, crotonic acid, cinnamic acid, α-cyanocinnamic acid, β-styrylacrylic acid, β-furfuryl acrylic acid, etc. may be cited. Among other unsaturated group-containing monocarboxylic acids cited above, acrylic acid and/or methacrylic acid prove to be desirable from the viewpoint of the influence on the photochemical reactivity and the properties of the cured product, particularly heat resistance, electrical insulating properties, and resistance to moisture absorption. These unsaturated group-containing monocarboxylic acids may be used either singly or in the form of a mixture of two or more members.

The curable resin (A) of the present invention is obtained by reacting a polybasic acid anhydride (f) with the reaction product (e) of theaforementioned reaction product (c) and the unsaturated group-containing monocarboxylic acid (d). In this reaction, the amount of use of the polybasic acid anhydride (f) is preferred to be in such an addition proportion that the acid value of the produced curable resin falls in the range of 30 to 150 mg KOH/g, more preferably 30 to 120 mg KOH/g. If the acid value of the curable resin is less than 30 mg KOH/g, it will be deficient in solubility in an aqueous alkaline solution and the coating film formed therefrom will be developed only with difficulty. Conversely, the acid value exceeding 150 mg KOH/g is not preferred because the coating film will be developed even in the surface of the exposed part without reference to the conditions of the exposure.

The reaction is performed in the presence of an organic solvent to be described hereinafter and in the presence of a polymerization inhibitor such as hydroquinone and oxygen, usually at a temperature in the approximate range of 50 to 150°C. In this reaction, as occasion demands, a tertiary amine such as triethylamine, a quaternary ammonium salt such as triethylbenzyl ammonium chloride, an imidazole compound such as 2-ethyl-4-methylimidazole, and a phosphorus compound such as triphenyl phosphine may be added to the reaction mixture as a catalyst.

As the polybasic acid anhydride (f) mentioned above, alicyclic dibasic acid anhydrides such as methyltetrahydrophthalic anhydride, tetrahydrophthalic anhydride, hexahydrophthalic anhydride, methylhexahydrophthalic anhydride, nadic anhydride, 3,6-endomethylenetetrahydrophthalic anhydride, methylendomethylenetetrahydrophthalic anhydride, and tetrabromophthalic anhydride; aliphatic or aromatic, dibasic or tribasic acid anhydrides such as succinic anhydride, maleic anhydride, itaconic anhydride, octenylsuccinic anhydride, pentadodecenylsuccinic anhydride, phthalic anhydride, and trimellitic anhydride; and aliphatic or aromatic tetrabasic acid dianhydrides such as biphenyl-tertacarboxylic dianhydride, diphenyl ether-tertacarboxylic dianhydride, butane-tertacarboxylic dianhydride, cyclopentane-tertacarboxylic dianhydride, pyromellitic anhydride, and benzophenonetetracarboxylic dianhydride may be cited. These polybasic acid anhydrides may be used either singly or in the form of a combination of two or more members. Among other polybasic acid anhydrides cited above, alicyclic dibasic acid anhydrides prove to be particularly desirable.

A photocurable resin composition may be formulated by compounding the above-mentioned curable resin of the present invention with a photopolymerization initiator (B) and can be photo-cured by exposure to actinic energy rays. Suitable light sources which are used for the purpose of photo-curing the composition are a low-pressure mercury vapor lamp, a medium-pressure mercury vapor lamp, a high-pressure mercury vapor lamp, an ultra-high-pressure mercury vapor lamp, a xenon lamp, and a metal halide lamp, for example. Also, a laser beam may be used as the active energy rays.

As the photopolymerization initiator (B), for example, benzoin and alkyl ethers thereof such as benzoin, benzoin methyl ether, benzoin ethyl ether, and benzoin isopropyl ether; acetophenones such as acetophenone, 2,2-dimethoxy-2-phenyl acetophenone, 2,2-diethoxy-2-phenyl acetophenone, and 1,1-dichloroacetophenone; aminoacetophenones such as 2-methyl-1-[4-(methylthio)phenyl]-2-morpholino-aminopropanone-1, 2-benzyl-2-dimethylamino-1-(4-morpholinophenyl)-butane-1-one, and N,N-dimethylamino-acetophenone; anthraquinones such as 2-methyl-anthraquinone, 2-ethylanthraquinone, 2-t-butylanthraquinone, and 1-chloroanthraquinone; thioxanthones such as 2,4-dimethylthioxanthone, 2,4-diethylthioxanthone, 2-chlorothioxanthone, and 2,4-diisopropylthioxanthone; ketals such as acetophenone dimethyl ketal and benzyl dimethyl ketal; dimer of 2,4,5-triaryl imidazole, riboflavin tetrabutylate, thiol compounds such as 2-mercaptobenzimidazole, 2-mercaptobenzoxazole, and 2-mercaptobenzothiazole; 2,4,6-tris-S-triazine; organic halogen compounds such as 2,2,2-tribromoethanol and tribromomethyl phenyl sulfone; benzophenones such as benzophenone and 4,4'-bis(diethylamino)benzophenone or xanthones; 2,4,6-trimethylbenzoyl diphenyl phosphine oxide, etc. may be cited. These well known and widely used photopolymerization initiators may be used either singly or in the form of a mixture of two or more members, or further in combination with a photo-initiator aid such as tertiary amines like N,N-(dimethylamino)ethylbenzoate, N,N-(dimethylamino)isoamylbenzoate, penthyl-4-dimethylaminobenzoate, triethyl amine, and triethanol amine. Further, a titanothene compound such as CGI-784 (product of Ciba Specialty Chemicals Inc.) and the like which exhibit absorption in a visible region may be added to promote the photochemical reaction. The photopolymerization initiator is not limited to the particular compounds enumerated above. Any compounds which absorb light in the ultraviolet region or visible region and cause radical polymerization of the unsaturated groups such as (meth)acryloyl groups may be used either singly or in the form of a combination of two or more members irrespective of the photopolymerization initiator or the photo-initiator aid.

The preferred combinations of the photopolymerization initiators include the combinations of 2-methyl-1-[4-(methylthio)-phenyl]-2-morphorino-aminopropanone-1 with 2,4-diethylthioxanthone, 2-isopropylthioxanthone, or 4-benzoyl-4'-methyldiphenyl sulfide, for example.

The amount of the aforementioned photopolymerization initiator (B) (in case the photo-initiator aid is used together, the total amount thereof) to be incorporated in the composition is desired to be in the range of 0.1 to 30 parts by weight, preferably 0.5 to 20 parts by weight, based on 100 parts by weight (as a solid content, this holds good for the same expression to be described hereinafter) of the curable resin (A or further F). If the amount of the photopolymerization initiator (B) to be incorporated is below the above range, the composition will not be photocured by irradiation of an actinic energy ray or the irradiation time should be prolonged, and the proper film properties will be obtained only with difficulty. Conversely, even if the photopolymerization initiator is added to the composition in a large amount exceeding the range mentioned above, the composition will not attain further improvement in the photo-curing properties and such a large amount is not desirable from the economical viewpoint.

Another photosensitive (meth)acrylate compound (C) may be incorporated into the curable resin composition of the present invention beside the above-mentioned curable resin (A) and the photopolymerization initiator (B) to improve the photo-curing properties thereof.

As the photosensitive (meth)acrylate compound (C), any photosensitive (meth)acrylate compound having one or more (meth)acryloyl groups in its molecule and assuming a liquid state, semi-solid state, or solid state at normal room temperature may be used. The photosensitive (meth)acrylate compound is used for the purpose of exalting the photochemical reactivity of the flame-retardant, photocurable and thermosetting resin composition. The photosensitive (meth)acrylate compound which is in the liquid state at normal room temperature will play the role of adjusting the flame-retardant, photocurable and thermosetting resin composition to such a degree of viscosity suitable for a varying method of application and aiding in enhancing the solubility of the composition in an aqueous alkaline solution besides the purpose of exalting the photochemical reactivity of the composition. However, the use of the photosensitive (meth) acrylate compound (C) assuming the liquid state at normal room temperature in a large amount is not preferred, because the produced coating film does not easily acquire necessary tack-free dryness and tends to have their properties degraded. The amount of the photosensitive (meth)acrylate compound (C) to be incorporated into the composition is desired to be in the range of 10 to 60 parts by weight, preferably 15 to 50 parts by weight, based on 100 parts by weight of the curable resin (A or further F). The use of this compound in a large amount exceeding the above range is not preferable because the tack-free dryness of a coating film will be degraded.

As the photosensitive (meth)acrylate compound (C), for example, hydroxyl group-containing acrylates such as 2-hydroxyethyl acrylate, 2-hydroxypropyl acrylate, pentaerythritol triacrylate, and dipentaerythritol pentaacrylate; water-soluble acrylates such as polyethylene glycol diacrylate and polypropylene glycol diacrylate; polyfunctional polyester acrylates of polyols such as trimethylolpropane triacrylate, pentaerythritol tetraacrylate, and dipentaerythritol hexaacrylate; acrylates of ethylene oxide adducts and/or propylene oxide adducts of polyhydric alcohols such as trimethylolpropane and hydrogenated bisphenol A or polyhydric phenols such as bisphenol A and biphenol; polyfunctional or monofunctional polyurethane acrylates which are aforementioned hydroxyl group-containing acrylates modified with isocyanate; epoxy acrylates which are (meth)acrylic acid adducts of bisphenol A diglycidyl ether, hydrogenated bisphenol A diglycidyl ether or phenol novolak epoxy resin, and methacrylates corresponding to the acrylates enumerated above may be cited. These compounds may be used either singly or in the form of a combination of two or more members. Among other compounds cited above, polyfunctional (meth)acrylate compounds having two or more (meth) acryloyl groups in their molecules prove to be particularly desirable.

The curable resin (A) of the present invention or the other curable resin (F) to be described hereinafter can be cured singly or together with a radically polymerizable cross-linking agent such as styrene or other photosensitive (meth)acrylate compound by a heat polymerization method using an organic peroxide, an azo compound, etc. or by a cold polymerization method using an organic peroxide and a promotor.

As the organic peroxide, t-butyl peroxybenzoate, t-butyl peroxy-2-ethylhexanoate, benzoyl peroxide, cyclohexanone peroxide, methyl ethyl ketone peroxide, bis-4-t-butyl cyclohexyl peroxydicarbonate, etc. may be cited. As the azo compound, azobisisobutyronitrile etc. may be cited. These organic peroxides and azo compounds may be used either singly or in the form of a combination of two or more members. The amount of these compounds to be used may be in the conventionally used range, generally in the range of 0.1 to 10 parts by weight, based on 100 parts by weight of the curable resin (A or further F).

As the promotor, any known compounds such as polyvalent metal salts like octoate, naphthenate, etc. of cobalt, iron, manganese, etc., and organic amines like dimethylaniline, diethylaniline, p-toluidine, ethanolamine, etc. may be used either singly or in the form of a combination of two or more members.

An epoxy compound (D) may be incorporated into the composition to formulate the curable resin composition together with the curable resin (A) of the present invention and to improve such properties as resistance to soldering heat and PCT resistance of a cured film thereof.

Although the amount of the epoxy compound (D) to be incorporated in the composition as a thermosetting component can be set suitably depending on the useage of the composition, generally it is proper to be set in the range

of 5 to 100 parts by weigh, based on 100 parts by weight of theaforementioned curable resin (A).

As the epoxy compound (D), bisphenol A type epoxy resins represented by EPIKOTE 828, EPIKOTE 834, EPIKOTE 1001, and EPIKOTE 1004 produced by Japan Epoxy Resin Co., Ltd., EPICLON 840, EPICLON 850, EPICLON 1050, and EPICLON 2055 produced by Dainippon Ink and Chemicals Inc., Epo Tohto YD-011, YD-013, YD-127, and YD-128 produced by Tohto Kasei Co., Ltd., and Sumi-epoxy ESA-011, ESA-014, ELA-115, and ELA-128 produced by Sumitomo Chemical Co., Ltd. (all trade names); brominated epoxy resins represented by EPIKOTE YL903 produced by Japan Epoxy Resin Co., Ltd., EPICLON 152 and EPICLON 165 produced by Dainippon Ink and Chemicals Inc., Epo Tohto YDB-400 and YDB-500 produced by Tohto Kasei Co., Ltd., and Sumi-epoxy ESB-400 and ESB-700 produced by Sumitomo Chemical Co., Ltd. (all trade names); novolak type epoxy resins represented by EPIKOTE 152 and EPIKOTE 154 produced by Japan Epoxy Resin Co., Ltd., EPICLON N-730, EPICLON N-770, and EPICLON N-865 produced by Dainippon Ink and Chemicals Inc., Epo Tohto YDCN-701 and YDCN-704 produced by Tohto Kasei Co., Ltd., EPPN-201, EOCN-1025, EOCN-1020, EOCN-104S, and RE-306 produced by Nippon Kayaku Co., Ltd., and Sumi-epoxy ESCN-195X and ESCN-220 produced by Sumitomo Chemical Co., Ltd. (all trade names); bisphenol F type epoxy resins represented by EPICLON 830 produced by Dainippon Ink and Chemicals Inc., EPIKOTE 807 produced by Japan Epoxy Resin Co., Ltd., and Epo Tohto YDF-170, YDF-175, and YDF-2004 produced by Tohto Kasei Co., Ltd. (all trade names); hydrogenated bisphenol A type epoxy resins represented by Epo Tohto ST-2004, ST-2007, and ST-3000 produced by Tohto Kasei Co., Ltd. (all trade names); glycidylamine type epoxy resins represented by EPIKOTE 604 produced by Japan Epoxy Resin Co., Ltd., Epo Tohto YH-434 produced by Tohto Kasei Co., Ltd., and Sumi-epoxy ELM-120 produced by Sumitomo Chemical Co., Ltd. (all trade names); alicyclic epoxy resins represented by Celloxide 2021 (trade name) produced by Daicel Chemical Industries, Ltd.; trihydroxyphenyl methane type epoxy resins represented by YL-933 produced by Japan Epoxy Resin Co., Ltd. and EPPN-501 and EPPN-502 produced by Nippon Kayaku Co., Ltd. (all trade names); bixylenol type or biphenol type epoxy resins or mixtures thereof represented by YL-6056, YX-4000, and YL-6121 produced by Japan Epoxy Resin Co., Ltd. (all trade names); bisphenol S type epoxy resins represented by EBPS-200 produced by Nippon Kayaku Co., Ltd., EPX-30 produced by Asahi Denka Kogyo K.K., and EXA-1514 produced by Dainippon Ink and Chemicals Inc. (all trade names); bisphenol A novolak type epoxy resins represented by EPIKOTE 157S (trade name) produced by Japan Epoxy Resin Co., Ltd.; tetraphenylol ethane type epoxy resins represented by EPIKOTE YL-931 (trade name) produced by Japan Epoxy Resin Co., Ltd.; heterocyclic epoxy resins represented by TEPIC (trade name) produced by Nissan Chemical Industries Ltd.; diglycidyl phthalate resin represented by BLEMMER-DGT (trade name) produced by Nippon Oil and Fats Co., Ltd.; tetraglycidyl xylenoyl ethane resins represented by ZX-1063 (trade name) produced by Tohto Kasei Co., Ltd.; naphthalene group-containing epoxy resins represented by ESN-190 and ESN-360 produced by Shinnittetsu Chemical Co., Ltd. and HP-4032, EXA-4750, and EXA-4700 produced by Dainippon Ink and Chemicals Inc. (all trade names); dicyclopentadiene skeleton-containing epoxy resins represented by HP-7200 and HP-7200H produced by Dainippon Ink and Chemicals Inc. (all trade names); glycidylmethacrylate copolymer type epoxy resins represented by CP-50S and CP-50M produced by Nippon Oil and Fats Co., Ltd. (all trade names); and copolymeric epoxy resin of cyclohexylmaleimide and glycidyl methacrylate may be cited. However, the epoxy compound is not limited to those enumerated above. These epoxy resins may be used either singly or in the form of a combination of two or more members.

A diluent solvent (E) is used for the purpose of dissolving the curable resin and the epoxy compound mentioned above and adjusting the viscosity of the composition to a level suitable for a coating method. The amount of the diluent solvent suitably falls in the approximate range of 10 to 300 parts by weight, based on 100 parts by weight of the total weight of the solid content of the curable resin (A or further F) and the solid content of the epoxy compound (D) and may be set at a suitable amount depending on the kind of method adopted for the application of the composition.

As the diluent solvent (E), for example, ketones such as methylethyl ketone and cyclohexanone; aromatic hydrocarbons such as toluene, xylene, and tetramethyl benzene; glycol esters such as methyl cellosolve, butyl cellosolve, methyl carbitol, butyl carbitol, propylene glycol monomethyl ether, dipropylene glycol monoethyl ether, dipropylene glycol diethyl ether, and triethylene glycol monoethyl ether; esters such as ethyl acetate, butyl acetate, butyl cellosolve acetate, and carbitol acetate; alcohols such as ethanol, propanol, ethylene glycol, and propylene glycol; aliphatic hydrocarbons such as octane and decane; and petroleum solvents such as petroleum ether, petroleum naphtha, hydrogenated petroleum naphtha, and solvent naphtha may be cited. These solvents may be used either singly or in the form of a mixture of two or more members.

Next, another curable resin (F) which is advantageously used in the photocurable and thermosetting resin composition of the present invention should be just a curable resin which has a carboxyl group and an unsaturated group in its molecule and which is in the state of solid at room temperature, as described above. As such a curable resin, for example, a curable resin obtained by adding an acid anhydride to a reaction product of a novolak type epoxy compound with an unsaturated group-containing monocarboxylic acid, a curable resin obtained by reacting tetrahydrophthalic anhydride with a reaction product of a novolak type epoxy resin, dimethylol propionic acid, and acrylic acid (JP 6-324490A), a curable resin obtained by reacting tetrahydrophthalic anhydride with a reaction product of a novolak type epoxy resin, acrylic acid, and p-hydroxyphenetyl alcohol (JP 11-288091A), a curable resin obtained by reacting

epihalohydrin with an alcoholic, secondary hydroxyl group of a reaction product of an aromatic epoxy resin having two glycidyl groups in its molecule and an aromatic alcoholic resin having two phenolic hydroxyl groups in its molecule and then adding an unsaturated group-containing monocarboxylic acid and subsequently an acid anhydride to the resultant reaction product, a vinyl copolymer obtained by reacting an acrylate of epoxycyclohexane methanol (for example, Cyclomer A200 manufactured by Daicel Chemical Industries, Ltd.) with a vinyl copolymer of methacrylic acid, methyl methacrylate, and lactone-modified 2-hydroxyethyl methacrylate (for example, Plaxcel FM1 manufactured by Daicel Chemical Industries, Ltd.) (JP 8-41150A), a vinyl copolymer obtained by reacting epoxycyclohexyl methyl acrylate (for example, Cyclomer A200 manufactured by Daicel Chemical Industries, Ltd.) with a vinyl copolymer of methacrylic acid and ε-caprolactone-modified 2-hydroxyethyl methacrylate modified with succinic acid (Plaxcel FM1A manufactured by Daicel Chemical Industries, Ltd. 1A) (JP 8-259624A), etc. may be cited. However, the other curable resin is not limited to those enumerated above.

In a preferred embodiment of the photocurable and thermosetting resin composition of the present invention, although the aforementioned curable resins (A) and (F) may be incorporated into the composition at any compounding ratio depending on the purpose of use, it is desirable that the compounding ratio of the curable resin (F) to the curable resin (A) should be 70:30 to 30:70 and that the acid value of the mixture should be in the range of 30 to 150 mg KOH/g, preferably 40 to 110 mg KOH/g. If the acid value of the mixture after compounding of the curable resins (A) and (F) is less than 30 mg KOH/g, it will be deficient in solubility in an aqueous alkaline solution and the coating film formed therefrom will be developed only with difficulty. Conversely, the acid value exceeding 150 mg KOH/g is not preferred because the coating film will be developed even in the surface of the exposed part without reference to the conditions of the exposure.

Further, a curing catalyst (G) may be used for the purpose of promoting the reaction between the curable resin and the epoxy compound. The curing catalyst (G) is particularly effective in further improving the properties of the solder resist such as resistance to soldering heat, adhesiveness, and resistance to electroless gold plating.

The amount of the curing catalyst (G) to be incorporated in the composition is preferred to be in the range of 0.01 to 25 parts by weight, more preferably 0.1 to 15 parts by weight, based on 100 parts by weight of the epoxy compound (D) mentioned above.

As the curing catalyst (G), for example, imidazole derivatives such as 2MZ, 2E4MZ, C11Z, C17Z, 2PZ, 1B2MZ, 2MZ-CN, 2E4MZ-CN, C11Z-CN, 2PZ-CN, 2PHZ-CN, 2MZ-CNS, 2E4MZ-CNS, 2PZ-CNS, 2MZ-AZINE, 2E4MZ-AZINE, C11Z-AZINE, 2MA-OK, 2P4MHZ, 2PHZ, 2P4BHZ, and 1B2PZ manufactured by Shikoku Chemicals Co., Ltd.; guanamines such as acetoguanamine and benzoguanamine; polyamines such as diaminodiphenyl methane, m-phenylene diamine, m-xylylene diamine, diaminodiphenyl sulfone, dicyandiamide, urea, urea derivatives, melamine, and polybasic hydrazide; and organic acid salts and/or epoxy adducts thereof; amine complexes of boron trifluoride; triazine derivatives such as ethyldiamino-S-triazine, 2,4-diamino-S-triazine, and 2,4-diamino-6-xylyl-S-triazine; tertiary amines such as trimethyl amine, triethanol amine, N,N-dimethyloctyl amine, N-benzyldimethyl amine, pyridine, N-methyl morpholine, hexa(n-methyl) melamine, 2,4,6-tris(dimethylaminophenol), tetramethyl guanidine, and m-aminophenol; polyphenols such as polyvinyl phenol, polyvinyl phenol bromide, phenol novolak, and alkylphenol novolaks; organic phospines such as tributyl phosphine, triphenyl phosphine, and tris-2-cyanoethyl phosphine; phosphonium salts such as tri-n-butyl (2,5-dihydroxyphenyl)phosphonium bromide and hexadecyltributyl phosphonium chloride; quaternary anunonium salts such as benzyltrimethyl ammonium chloride and phenyltributyl ammonium chloride; anhydrides of the polybasic acids mentioned above; photo-cationic polymerization catalysts such as diphenyl iodonium tetrafluoroborate, triphenyl sulfonium hexafluoroantimonate, 2,4,6-triphenyl thiopyrilium hexafluorophosphate, IRGACURE 261 manufactured by Ciba Specialty Chemicals Inc., and Optomer SP-170 manufactured by Asahi Denka Co., Ltd.; styrene-maleic anhydride resin; an equimolar reaction product of phenyl isocyanate and dimethylamine, equimolar reaction products of dimethylamine and an organic polyisocyanate such as trylene diisocyanate and isophorone diisocyanate, and other well known and commonly used curing agents or curing promoters may be cited. These curing agents or curing promoters may be used either singly or in the form of a combination of two or more members.

Any flame-retardant which has been heretofore added to a resin to be used in elecrical equipment can be used as the flame-retardant (H) which is to be incorporated into the photocurable and thermosetting resin composition of the present invention without limitation. Among other flame-retardants, a halogen-based flame-retardant, a phosphorus-based flame-retardant, and an antimony-based flame-retardant prove to be preferable from the viewpoint of compatibility with resin, heat resistance, etc.

The amount of the flame-retardant (H) to be incorporated into the composition is generally in the range of 1 to 200 parts by weight, preferably 5 to 50 parts by weight, based on 100 parts by weight of the total weight of a solid content of the curable resin (A or further F) mentioned above and a solid content of the epoxy compound (D). If the amount of the flame-retardant (H) falls in the above-mentioned range, the fire retardancy, resistance to soldering heat, and electrical insulating properties of the resin composition are advantageously balanced at a high level.

As the halogen-based flame-retardant, halogenated aromatic compounds such as hexabromobenzene, pentabromoethyl benzene, hexabromobiphenyl, decabromodiphenyl, hexabromodiphenyl oxide, octabromodiphenyl

oxide, decabromodiphenyl oxide, tribromophenyl glycidyl ether, tribromophenylacrylate, ethylene-bis-tribromophenyl ether, ethylene-bis-pentabromophenyl ether, tetradecabromodiphenoxy benzene, octabromonaphthalene, bis(tribromophenyl) fumaramide, and N-methyl-hexabromodiphenylamine; halogenated bisphenols such as tetrabromobisphenol A and derivatives thereof [for example, tetrabromobisphenol A-bis(hydroxyethyl ether), tetrabromobisphenol A-bis(2,3-dibromopropyl ether), tetrabromobisphenol A-bis(bromoethyl ether), tetrabromobisphenol A-bis(allyl ether), etc.], tetrabromobisphenol S and derivatives thereof [for example, tetrabromobisphenol S-bis(hydroxyethyl ether), tetrabromobisphenol S-bis(2,3-dibromopropyl ether), etc], halogenated epoxy resins such as brominated epoxy resin; halogenated aromatic polymers such as brominated polystyrene, brominated polyphenylene oxide, brominated polycarbonate, and polypentabromobenzyl acrylate; halogenated alicyclic compounds such as ethylene-bis(5,6-dibromonorbornene-2,3-dicarboxyimide), pentabromocyclohexanone, a Diels-Alder reaction adduct of hexachlorocyclopentadiene, and hexabromocyclododecane; tetrabromophthalic anhydride and derivatives thereof [for example, tetrabromophthalimide, ethylene-bis-tetrabromophthalimide, etc.], tris-(2,3-dibromopropyl-1)-isocyanurate, etc. may be cited.

As the phosphorus-based flame-retardant, halogen-containing phosphate flame-retardants such as tris(chloroethyl) phosphate, tris(2,3-dichloropropyl) phosphate, tris(2-chloropropyl) phosphate, tris(2,3-bromopropyl) phosphate, tris(bromochloropropyl) phosphate, 2,3-dibromopropyl-2,3-chloropropyl phosphate, tris(tribromophenyl) phosphate, tris(dibromophenyl) phosphate, and tris(tribromoneopentyl) phosphate; and non-halogen type flame-retardants such as aliphatic phosphates like trimethyl phosphate, triethyl phosphate, tributyl phosphate, trioctyl phosphate, and tributoxyethyl phosphate; aromatic phosphates like triphenyl phosphate, cresyl diphenyl phosphate, dicresyl phenyl phosphate, tricresyl phosphate, trixylenyl phosphate, xylenyl diphenyl phosphate, tris(isopropyl phenyl) phosphate, isopropylphenyl diphenyl phosphate, diisopropylphenyl phenyl phosphate, tris(trimethylphenyl) phosphate, tris(t-butylphenyl) phosphate, hydroxyphenyl diphenyl phosphate, and octyl diphenyl phosphate may be cited.

As the antimony-based flame-retardant, antimony oxide type flame-retardants such as antimony trioxide and antimony pentaoxide, sodium antimonate, etc. may be cited.

The flame-retardant (H) mentioned above may be used singly or in the form of the combination of two or more members.

The photocurable and thermosetting resin composition of the present invention may further incorporate therein, as occasion demands, a well known and widely used inorganic filler such as barium sulfate, barium titanate, silicon oxide powder, finely pulverized silicon oxide, amorphous silica, talc, clay, magnesium carbonate, calcium carbonate, aluminum oxide, aluminum hydroxide, and mica powder for the purpose of improving such properties as adhesiveness and hardness. The amount of the inorganic filler to be used is preferred to be in the range of 0 to 60 wt.%, more preferably 5 to 40 wt.% of the whole composition of the present invention.

The composition may further incorporate therein, as occasion demands, any of known and commonly used coloring agents such as phthalocyanine blue, phthalocyanine green, iodine green, disazo yellow, crystal violet, titanium oxide, carbon black, and naphthalene black, any of known and commonly used polymerization inhibitors such as hydroquinone, hydroquinone monomethyl ether, tert-butyl catechol, pyrogallol, and phenothiazine, any of known and commonly used thickening agents such as asbestos, organobentonite, benton, and montmorillonite, silicone type, fluorine type, or macromolecular type anti-foaming agents and/or leveling agents, adhesiveness-imparting agents such as imidazole-based, thiazole-based, or triazole-based silane coupling agents, or any other known and commonly used additives.

Further, the photocurable and thermosetting resin composition of the present invention can be modified so as to be developable with water by forming a salt of the carboxyl group of the curable resin component (A, F) with an amine such as trimethylamine and triethylamine, or a tertiary amino group-containing (meth)acrylate compound such as N,N-dimethylaminoethyl (meth)acrylate, N,N-dimethylaminopropyl (meth)acrylamide, N,N-dimethyl (meth)acrylamide, acryloyl morpholine, N-isopropyl (meth)acrylamide, and N-methylol acrylamide.

The photocurable and thermosetting resin composition of the present invention is obtained by compounding the components mentioned above, preferably in the proportion mentioned above, and homogeneously mixing them with a roll mill or the like.

The photocurable and thermosetting resin composition of the present invention can be cured as follows to obtain a cured product. That is, the photocurable and thermosetting resin composition of the present invention is applied by the technique of screen printing, spraying, roll coating, electrostatic coating, curtain coating, or the like to a printed circuit board to form a coating film of 10-100 µm thickness and then the coating film is dried at a temperature in the range of 60 to 110°C. Thereafter, a negative film is directly brought into contact with the coating film (or placed over the coating film in the non-contact state). Then, the coating film is irradiated with ultraviolet light and the unexposed area of the coating film is developed with a dilute aqueous alkaline solution (such as, for example, an aqueous solution of 0.5 to 2% sodium carbonate) to dissolve out the unexposed portion (development). Thereafter, for the purpose of improving various properties, the coating film is further cured sufficiently by irradiation with ultraviolet light and/or by heating (for example, at 100 to 200°C for 0.5 to 1 hour) to give birth to a cured film.

Now, the present invention will be more specifically described below with reference to synthetic examples, working examples and comparative examples. As a matter of course, the present invention is not limited to the following examples. Wherever "parts" is mentioned hereinbelow, it invariably refers to that based on weight unless otherwise specified.

Synthetic Example 1:

Into an autoclave equipped with a thermometer, a device for introduction of nitrogen and alkylene oxide, and a stirrer, 98 parts of a polyphenol resin which is a condensation product of phenols and a phenolic hydroxyl group-containing aromatic aldehyde (manufatured by Japan Epoxy Resin Co., Ltd., trade name "EPICURE YL6065", OH equivalent: 98), 0.98 part of potassium hydroxide, and 98 parts of toluene were charged. The air in the system chamber was replaced with nitrogen while stirring the mixture and the temperature of the mixture was increased by heating. Then, 63.8 parts of propylene oxide was gradually added dropwise to the mixture and the resultant mixture was left reacting for 16 hours at 125-132°C under a pressure of 0-4.8 kg/cm$^2$. Thereafter, The reaction solution was cooled to room temperature. To this reaction solution, 1.28 parts of 89% phosphoric acid was added and mixed therewith to neutralize potassium hydroxide. The obtained reaction solution of propylene oxide to the polyphenol resin had a nonvolatile content of 63.8% and the hydroxyl equivalent of 160.7 g/eq. This means that 1.08 mols of the alkylene oxide was added to one equivalent of the phenolic hydroxyl group on average.

251.8 parts of the reaction solution of propylene oxide to the polyphenol resin obtained as above, 36.0 parts of acrylic acid, 9.6 parts of methanesulfonic acid, 0.18 part of methyl hydroquinone, and 217.3 parts of toluene were charged into a reaction vessel equipped with a stirrer, a thermometer, and an air blowing tube and left reacting for 12 hours at 110°C while blowing air thereinto at a rate of 10 ml/min. and stirring the mixture. 9.8 parts of water caused by the reaction was distilled out together with toluene as an azeotropic mixture. Thereafter, the reaction solution was cooled to room temperature. The obtained reaction solution was neutralized with 29.4 parts of an aqueous 15% sodium hydroxide solution and then washed with water. Thereafter, toluene was distilled out by means of an evaporator while replacing it with 109.0 parts of diethylene glycol monoethyl ether acetate to obtain an unsaturated group-containing curable resin solution having a nonvolatile content of 63.3%.

Next, 296.4 parts of the resultant unsaturated group-containing curable resin solution and 1.22 parts of triphenylphosphine were charged into a reaction vessel equipped with a stirrer, a thermometer, and an air blowing tube. 76.0 parts of tetrahydrophthalic anhydride was gradually added to the mixture while blowing air thereinto at a rate of 10 ml/min. and stirring the mixture, and they were left reacting for 6 hours at 95-105°C. The product was cooled and then extracted from the reaction vessel. The curable resin consequently obtained was found to have a nonvolatile content of 71.8% and an acid value of 109.6 mg KOH/g as solids.

The infrared absorption spectrum (measured by the use of a Fourier-transform infrared spectrophotometer, FT-IR) of the curable resin obtained in this synthetic example is shown in Fig. 1.

Synthetic Example 2:

Into an autoclave equipped with a thermometer, a device for introduction of nitrogen and alkylene oxide, and a stirrer, 98 parts of the polyphenol resin (manufatured by Japan Epoxy Resin Co., Ltd., trade name "EPICURE YL6065", OH equivalent: 98), 0.98 part of potassium hydroxide, and 98 parts of toluene were charged. The air in the system chamber was replaced with nitrogen while stirring the mixture and the temperature of the mixture was increased by heating. Then, 174.0 parts of propylene oxide was gradually added dropwise to the mixture and the resultant mixture was left reacting for 16 hours at 125-132°C under a pressure of 0-4.8 kg/cm$^2$. Thereafter, The reaction solution was cooled to room temperature. To this reaction solution, 1.28 parts of 89% phosphoric acid was added and mixed therewith to neutralize potassium hydroxide. The obtained reaction solution of propylene oxide to the polyphenol resin had a nonvolatile content of 75.1% and the hydroxyl equivalent of 264.5 g/eq. This means that 2.87 mols of the alkylene oxide was added to one equivalent of the phenolic hydroxyl group on average.

352.2 parts of the reaction solution of propylene oxide to the polyphenol resin obtained as above, 43.2 parts of acrylic acid, 11.53 parts of methanesulfonic acid, 0.18 part of methyl hydroquinone, and 273.5 parts of toluene were charged into a reaction vessel equipped with a stirrer, a thermometer, and an air blowing tube and left reacting for 12 hours at 110°C while blowing air thereinto at a rate of 10 ml/min. and stirring the mixture. 9.3 parts of water caused by the reaction was distilled out together with toluene as an azeotropic mixture. Thereafter, the reaction solution was cooled to room temperature. The obtained reaction solution was neutralized with 35.35 parts of an aqueous 15% sodium hydroxide solution and then washed with water. Thereafter, toluene was distilled out by means of an evaporator while replacing it with 203.5 parts of diethylene glycol monoethyl ether acetate to obtain an unsaturated group-containing curable resin solution having a nonvolatile content of 59.4%.

Next, 500.0 parts of the resultant unsaturated group-containing curable resin solution and 1.22 parts of triphenylphosphine were charged into a reaction vessel equipped with a stirrer, a thermometer, and an air blowing tube. 60.8 parts of tetrahydrophthalic anhydride was gradually added to the mixture while blowing air thereinto at a rate of 10 ml/min. and stirring the mixture, and they were left reacting for 6 hours at 95-105°C. The product was cooled and then extracted from the reaction vessel. The curable resin consequently obtained was found to have a nonvolatile content of 64.7% and an acid value of 65.5 mg KOH/g as solids.

Synthetic Example 3:

Into an autoclave equipped with a thermometer, a device for introduction of nitrogen and alkylene oxide, and a stirrer, 120 parts of a poly-p-hydroxystyrene resin (manufatured by Maruzen Petrochemical Co., Ltd., trade name "MARUKA LYNCUR M", OH equivalent: 120), 1.2 parts of potassium hydroxide, and 120 parts of toluene were charged. The air in the system chamber was replaced with nitrogen while stirring the mixture and the temperature of the mixture was increased by heating. Then, 63.8 parts of propylene oxide was gradually added dropwise to the mixture and the resultant mixture was left reacting for 16 hours at 125-132°C under a pressure of 0-4.8 kg/cm$^2$. Thereafter, The reaction solution was cooled to room temperature. To this reaction solution, 1.57 parts of 89% phosphoric acid was added and mixed therewith to neutralize potassium hydroxide. The obtained reaction solution of propylene oxide to the poly-p-hydroxystyrene resin had a nonvolatile content of 62.0% and the hydroxyl equivalent of 182 g/eq. This means that 1.07 mols of the alkylene oxide was added to one equivalent of the phenolic hydroxyl group on average.

293.0 parts of the reaction solution of propylene oxide to the poly-p-hydroxystyrene resin obtained as above, 43.2 parts of acrylic acid, 11.53 parts of methanesulfonic acid, 0.18 part of methyl hydroquinone, and 252.9 parts of toluene were charged into a reaction vessel equipped with a stirrer, a thermometer, and an air blowing tube and left reacting for 12 hours at 110°C while blowing air thereinto at a rate of 10 ml/min. and stirring the mixture. 12.6 parts of water caused by the reaction was distilled out together with toluene as an azeotropic mixture. Thereafter, the reaction solution was cooled to room temperature. The obtained reaction solution was neutralized with 35.35 parts of an aqueous 15% sodium hydroxide solution and then washed with water. Thereafter, toluene was distilled out by means of an evaporator while replacing it with 118.1 parts of diethylene glycol monoethyl ether acetate to obtain an unsaturated group-containing curable resin solution.

Next, 332.0 parts of the resultant unsaturated group-containing curable resin solution and 1.22 parts of triphenylphosphine were charged into a reaction vessel equipped with a stirrer, a thermometer, and an air blowing tube. 60.8 parts of tetrahydrophthalic anhydride was gradually added to the mixture while blowing air thereinto at a rate of 10 ml/min. and stirring the mixture, and they were left reacting for 6 hours at 95-101°C. The product was cooled and then extracted from the reaction vessel. The curable resin consequently obtained was found to have a nonvolatile content of 71.8% and an acid value of 85.3 mg KOH/g as solids. Comparative Synthetic Example 1:

In a four-necked flask equipped with a stirrer and a reflux condenser, 220 parts of a cresol novolak type epoxy resin (manufactured by Nippon Kayaku Co., Ltd., trade name ECON-104S, epoxy equivalent; 220) and 218 parts of carbitol acetate added thereto were dissolved by heating. Then, 0.46 part of methyl hydroquinone as a polymerization inhibitor and 1.38 parts of triphenylphosphine as a reaction catalyst were added to the solution. The resultant mixture kept heated to 95-105°C and 50.4 parts of acrylic acid and 41.5 parts of p-hydroxyphenetyl alcohol gradually added dropwise thereto were left reacting for 16 hours. The reaction product was cooled to 80-90°C and made to add 91.2 parts of tetrahydrophthalic anhydride and they were left reacting for 8 hours. The product was cooled and then extracted from the flask. The curable resin consequently obtained was found to have a nonvolatile content of 65% and an acid value of 84 mg KOH/g as solids.

Examples 1-3 and Comparative Example 1:

The curable resin compositions were prepared by compounding relevant components at proportions (numerical values indicate parts by weight) shown in Table 1 and kneading them with a three-roll mill, respectively. Each of the curable resin compositions was applied by the screen printing method using a polyester screen of 100 mesh to the entire surface of a copper plated-throughhole printed circuit board having a prescribed pattern formed in advance thereon to form a coating film of 20-30 μm thickness. The coating film on the board was dried by the use of a hot air drying oven at 80°C for 30 minutes. The coating film was irradiated with ultraviolet light by using an ultraviolet exposure apparatus (product of ORC Manufacturing Co., Ltd., Model HMW-680GW) through a negative film having a prescribed resist pattern and tightly superposed on the coating film under the conditions of irradiation dose of 600 mJ/cm$^2$. Then, the coating film was developed for 60 seconds with an aqueous 1% sodium carbonate solution applied by spraying at a pressure of 2.0 kg/cm$^2$ to dissolve out the unexposed portion. Thereafter, the coating film on the board was thermally cured in a hot air drying oven at 150°C for 60 minutes to prepare a test board.

The resultant test board having the cured film was tested for the resistance to soldering heat, PCT resistance, adhesiveness, acid resistance, alkali resistance, and resistance to electroless gold plating in accordance with the

testing method and the evaluation method to be described hereinafter.

Further, by using a B pattern of a printed circuit board (thickness: 1.6 mm) specified by IPC in place of the copper plated-throughhole printed circuit board, a test board was prepared under the same conditions as described above and the electrical resistance was measured. Furthermore, a glass plate used in place of the copper plated-throughhole printed circuit board was treated under the same conditions as described above to obtain the water absorption.

The results of the above tests are shown in Table 2.

Table 1

| Components (parts by weight) | | Example | | | Comparative Example 1 |
|---|---|---|---|---|---|
| | | 1 | 2 | 3 | |
| Curable resin | Resin of Synthetic Example 1 | 139.3 | - | - | - |
| | Resin of Synthetic Example 2 | - | 154.5 | - | - |
| | Resin of Synthetic Example 3 | - | - | 139.3 | - |
| | Resin of Comparative Synthetic Example 1 | - | - | - | 153.8 |
| Irgacure 907 *1) | | 14.0 | 14.0 | 14.0 | 14.0 |
| DETX-S *2) | | 1.0 | 1.0 | 1.0 | 1.0 |
| Diethylene glycol monoethyl ether acetate | | 11.0 | 11.0 | 11.0 | 11.0 |
| Phthalocyanine blue | | 1.5 | 1.5 | 1.5 | 1.5 |
| Silicone KS-66 *3) | | 2.0 | 2.0 | 2.0 | 2.0 |
| AEROSIL 380 *4) | | 3.0 | 3.0 | 3.0 | 3.0 |
| Melamine | | 1.5 | 1.5 | 1.5 | 1.5 |
| DPHA *5) | | 15.0 | 15.0 | 15.0 | 15.0 |
| RE306 *6) | | 16.4 | 9.8 | 12.8 | 12.6 |
| Epo-Thoto YDCN 704P *7) | | 41.0 | 24.5 | 31.9 | 31.4 |
| Remarks | | | | | |

*1) Irgacure 907: 2-methyl-1-[4-(methylthio)phenyl]-2-marpholino-aminapropanone-1 (produced by Ciba Specialty Chemicals Inc.)
*2) DETX-S: 2,4-diethylthioxanthone (produced by Nippon Kayaku Co., Ltd.)
*3) Silicone KS-66: Silicone type anti-foaming agent (produced by Shinetsu Silicone Co., Ltd.)
*4) AEROSIL 380: finely pulverized silica (produced by Nippon Aerosil Co., Ltd.)
*5) DPHA: a mixture of dipentaerythritol hexa- and penta-acrylates (produced by Nippon Kayaku Co., Ltd.)
*6) RE306: novolak type epoxy resin (produced by Nippon Kayaku Co., Ltd.)
*7) Epo-Thoto YDCN-704P: novolak type epoxy resin (produced by Thoto Kasei Co., Ltd.)

Table 2

| Properties | Example | | | Comparative |
|---|---|---|---|---|
| | 1 | 2 | 3 | Example 1 |
| Resistance to soldering heat | ○ | ○ | ○ | ○ |
| PCT resistance | ○ | ○ | ○ | Δ |
| Adhesiveness | ◎ | ◎ | ◎ | × |
| Acid resistance | ○ | ○ | ○ | ○ |
| Alkali resistance | ○ | ○ | ○ | ○ |
| Resistance to electoless gold plating | ○ | ○ | ○ | Δ |
| Electrical resistance | ○ | ○ | ○ | ○ |
| Water absorption (%) | 0.9 | 1.1 | 1.0 | 1.7 |

The methods for testing and evaluating the characteristics shown in Table 2 mentioned above are as follows:

Resistance to Soldering Heat:

A test board was repeatedly immersed in a solder bath kept at 260°C three times each for 10 seconds in accordance with the method specified in JIS C 6481 and visually examined the change in appearance on the following criterion. Incidentally, a flux according to JIS C 6481 was used as a post flux (rosin type).

○: No discernible change in appearance
Δ: Discoloration of the cured film observed
×: Lifting or separation of the cured film, or infiltration of solder observed

PCT Resistance:

The test board mentioned above was further left standing for 5 hours in a hot air drying oven kept at 170°C. Thereafter, the PCT resistance of the cured film was measured under the conditions of 50 hours in saturated steam kept at 121°C and evaluated on the following criterion.

○: No discernible blister, separation, or discoloration of the cured film observed
Δ: Slight blister, separation, or discoloration of the cured film observed
× : Blister, separation, or discoloration of the cured film observed

Adhesiveness:

The cured film on the test board was incised like cross-cut in the shape of squares in a go board and then subjected to a peeling test with an adhesive cellophane tape in accordance with the method specified in JIS D 0202. The degree of separation of the cured film after the peeling test was evaluated on the following criterion.

◎ : 100/100 and absolutely no peeling of the cured film
○: 100/100, but slight peeling in the cross-cut portions
Δ: 50/100 - 90/100
×: 0/100 - 50/100

Acid Resistance:

This property was determined by keeping the test board mentioned above immersed in an aqueous 10 vol. % sulfuric acid solution at 20°C for 30 minutes, removing the test board from the solution, and evaluating the test board with respect to the cured film condition on the following criterion.

○: Absence of discernible change
Δ: Very slight presence of change
×: Occurrence of blister or swell or separation of cured film

Alkali Resistance:

This property was determined by following the procedure of the acid resistance test except that an aqueous 10 vol.% sodium hydroxide solution was used in place of the aqueous 10 vol.% sulfuric acid solution.

Resistance to Electroless Gold Plating:

On the test board mentioned above, electroless gold plating was effected according to the steps as specified below. Then the test board was examined as to the change in appearance and subjected to a peeling test with the use of an adhesive cellophane tape and the peeling conditions of the cured film were evaluated on the following criterion.

○: Neither any change in appearance nor peeling of the cured film was observed.
Δ: No change in appearance was observed, though slight peeling of the cured film was observed.
× : The cured film suffered from lifting and plating penetration, and significant peeling of the cured film was observed in the peeling test.

Electroless Gold Plating Process:

1. Degreasing:

The test board was immersed in an acidic degreasing solution (an aqueous 20 vol. % solution of Metex L-5B manufactured by Japan MacDermid Co., Ltd.) at 30°C for 3 minutes.

2. Rinsing:

The test board was immersed in running water for 3 minutes.

3. Soft etching:

The test board was immersed in an aqueous 14.3 wt.% ammonium persulfate solution at room temperature for 3 minutes.

4. Rinsing:

The test board was immersed in running water for 3 minutes.

5. Immersion in acid:

The test board was immersed in an aqueous 10 vol.% sulfuric acid solution for one minute at room temperature.

6. Rinsing:

The test board was immersed in running water for 30 seconds to one minute.

7. Introduction of catalyst:

The test board was immersed in a catalyst solution (an aqueous 10 vol.%. solution of Metal Plate Activator 350 manufactured by Meltex Inc.) at 30°C for 7 minutes.

8. Rinsing:

The test board was immersed in running water for 3 minutes.

9. Electroless nickel plating:

The test board was immersed in a nickel plating solution (an aqueous 20 vol.% solution of Melplate Ni-865M manufactured by Meltex Inc.) of pH 4.6 at 85°C for 20 minutes.

10. Immersion in acid:

The test board was immersed in an aqueous 10 vol.% sulfuric acid solution at room temperature for one minute.

11. Rinsing:

The test board was immersed in running water for 30 seconds to one minute.

12. Electroless gold plating:

The test board was immersed in a gold plating solution (an aqueous solution of 15 vol.% of Aurolectroless UP manufactured by Meltex Inc. and 3 vol.% of gold potassium cyanide) of pH 6 at 95°C for 10 minutes.

13. Rinsing:

The test board was immersed in running water for 3 minutes.

14. Rinsing with hot water:

The test board was immersed in hot water at 60°C for 3 minutes. After sufficient washing with water and thorough draining, the test board was dried.

After the above steps, an electroless gold plated test board was obtained.

Electrical Insulating Properties:

The electrical insulating properties of the cured film mentioned above was evaluated on the following criterion.

Moistening conditions: temperature 85°C, humidity 85%R.H., applied voltage 100V, 500 hours

Measurement conditions: measurement time 60 seconds, applied voltage 500V

○: Insulation resistance after moistening is not less than $10^9$ Ω and no migration of copper is found.
Δ: Insulation resistance after moistening is not less than $10^9$ Ω, but migration of copper is found.
×: Insulation resistance after moistening is not more than $10^8$ Ω and migration of copper is found.

Water Absorption:

The test board mentioned above was treated for 24 hours by the use of a PCT apparatus (TABAI ESPEC HAST SYSTEM TPC-412MD) under the conditions of 121°C and 100% R.H. The water absorption of the cured film was calculated by the following equation:

$$\text{Water absorption (\%)} = [(W2 - W1)/(W1 - Wg)] \times 100$$

where W1 is the weight of the test board, W2 is the weight of the test board after the PCT treatment, and Wg is the weight of the glass plate.

Synthetic Example 4:

Into a separable flask of 2 liters equipped with a stirrer, a thermometer, a reflux condenser, a dropping funnel, and a nitrogen introduction tube, 900 parts of diethylene glycol dimethyl ether and 21.4 parts of t-butylperoxy-2-ethylhexanoate (manufactured by Nippon Oil & Fat Co., Ltd., Perbutyl O) were charged. After the temperature of the mixture was increased to 90°C by heating, 309.9 parts of methacrylic acid, 116.4 parts of methyl methacrylate, 109.8 parts of lactone-modified 2-hydroxyethyl methacrylate (manufactured by Daicel Chemical Industries, Ltd., Plaxcel FM1), and 21.4 parts of bis(4-t-butyl cyclohexyl)peroxydicarbonate (manufactured by Nippon Oil & Fat Co., Ltd., Peroyl TCP) were dropwise introduced into diethylene glycol dimethyl ether for 3 hours and left standing for maturing for 6 hours to obtain a carboxyl group-containing vinyl copolymer solution. The reaction was carried out under a stream of $N_2$ gas.

Next, 363.9 parts of an acrylate of epoxycyclohexane methanol (manufactured by Daicel Chemical Industries, Ltd., Cyclomer A200), 3.6 parts of dimethylbenzylamine, and 1. 80 parts of hydrquinone monomethyl ether were added to the resultant vinyl copolymer solution and the temperature of the mixture was increased to 100°C while stirring it to effect the ring opening addition reaction of epoxy. The curable resin consequently obtained was found to have a nonvolatile content of 53.8% and an acid value of 107 mg KOH/g as solids.

Synthetic Example 5:

In a flask equipped with a gas introduction tube, a stirrer, a condenser, and a thermometer, 330 parts of a cresol novolak type epoxy resin (manufactured by Dainippon Ink & Chemicals, Inc., EPICLON N-695, epoxy equivalent; 220) and 400 parts of carbitol acetate added thereto were dissolved by heating. Then, 0.46 part of hydroquinone and 1.38 parts of triphenylphosphine were added to the solution. The resultant mixture kept heated to 95-105°C and 108 parts of acrylic acid gradually added dropwise thereto were left reacting for 16 hours. The reaction product was cooled to 80-90°C and made to add 163 parts of tetrahydrophthalic anhydride and they were left reacting for 8 hours. The reaction was followed up by the addition ratio obtained by the total acid value and the acid value of the reaction solution measured by potentiometric titration and the reaction ratio of 95% or more was regarded as the completion of the

reaction. The curable resin consequently obtained was found to have a nonvolatile content of 58% and an acid value of 102 mg KOH/g as solids.

Examples 4-6:

The photocurable and thermosetting resin compositions were prepared by compounding relevant components at proportions (numerical values indicate parts by weight) shown in Table 3 and kneading them with a three-roll mill, respectively. Each of the compositions was applied by the screen printing method using a polyester screen of 100 mesh to the entire surface of a copper plated-throughhole printed circuit board having a prescribed pattern formed in advance thereon to form a coating film of 20-30 µm thickness. The coating film on the board was dried by the use of a hot air drying oven at 80°C for 60 minutes to evaluate the tack-free dryness of the surface of the coating film in accordance with the evaluation method to be described hereinafter.

Next, the coating film was irradiated with ultraviolet light by using an ultraviolet exposure apparatus (product of ORC Manufacturing Co., Ltd., Model HMW-680GW) through a negative film having a prescribed resist pattern and tightly superposed on the coating film (irradiation dose: 600 $mJ/cm^2$). Then, the coating film was developed for 60 seconds with an aqueous 1% sodium carbonate solution applied by spraying at a pressure of 2.0 $kg/cm^2$ and the developing properties were evaluated in accordance with the evaluation method to be described hereinafter.

Thereafter, the coating film on the board was thermally cured in a hot air drying oven at 150°C for 60 minutes to prepare a test board. The resultant test board having the cured film was tested for the adhesiveness, resistance to soldering heat, acid resistance, alkali resistance, resistance to electroless gold plating, and PCT resistance in accordance with the testing method and the evaluation method described hereinbefore.

Further, by using a B pattern of a printed circuit board (thickness: 1.6 mm) specified by IPC in place of the copper plated-throughhole printed circuit board, a test board was prepared under the same conditions as described above and the electrical resistance was tested.

The results of each of the above tests are shown in Table 4.

Table 3

| Components (parts by weight) | | Example | | |
|---|---|---|---|---|
| | | 4 | 5 | 6 |
| Curable resin | Resin of Synthetic Example 1 | 97.5 | - | 139.3 |
| | Resin of Synthetic Example 3 | - | 83.6 | - |
| | Resin of Synthetic Example 4 | 55.8 | - | - |
| | Resin of Synthetic Example 5 | - | 69.0 | - |
| Irgacure 907 *1) | | 15.0 | 15.0 | 15.0 |
| DETX-S *2) | | 0.5 | 0.5 | 0.5 |
| Diethylene glycol monoethyl ether acetate | | 11.0 | 11.0 | 7.0 |
| Phthalocyanine green | | 1.5 | 1.5 | 1.5 |
| Silicone KS-66 *3) | | 2.0 | 2.0 | 2.0 |
| AEROSIL 380 *4) | | 2.0 | 2.0 | 2.0 |
| Melamine | | 1. 5 | 1. 5 | 1. 5 |
| DPHA *5) | | 20.0 | 20.0 | 20.0 |
| RE306 *6) | | 14.1 | 13.8 | 16.4 |
| Epo-Thoto YDCN 704P *7) | | 35.2 | 34.4 | 41.0 |

*1) Irgacure 907: 2-methyl-1-[4-(methylthio)phenyl]-2-mcrpholino-aminopropanone-1 (produced by Ciba Specialty Chemicals Inc.)
*2) DETX-S: 2,4-diethylthioxanthone (produced by Nippon Kayaku Co., Ltd.)
*2) *3) silicone KS-66: Silicone type anti-foaming agent (produced by Shinetsu Silicone Co., Ltd.)
*4) *4) AEROSIL 380: finely pulverized silica (produced by Nippon Aerosil Co., Ltd.)
*5) DPHA: a mixture of dipentaerythritol hexa- and penta-acrylates (produced by Nippon Kayaku Co., Ltd.)
*6) RE306: novolak type epoxy resin (produced by Nippon Kayaku Co., Ltd.)
*7) Epo-Thoto YDCN-704P: novolak type epoxy resin (produced by Thoto Kasei Co., Ltd.)

Table 3 (continued)

| Components (parts by weight) | Example | | |
|---|---|---|---|
| | 4 | 5 | 6 |
| YX-4000 *8) | 9.3 | 9.1 | 10.8 |
| Remarks | | | |

*8) YX-4000: bixylenol type epoxy resin (produced by Japan Epoxy Resin Co., Ltd.)

Table 4

| Properties | Example | | |
|---|---|---|---|
| | 4 | 5 | 6 |
| Tack-free dryness | ○ | ○ | × |
| Developing Properties | ○ | ○ | ○ |
| Adhesiveness | ◎ | ◎ | ◎ |
| Resistance to soldering heat | ○ | ○ | ○ |
| Acid resistance | ○ | ○ | ○ |
| Alkali resistance | ○ | ○ | ○ |
| Resistance to electoless gold plating | ○ | ○ | ○ |
| PCT resistance | ○ | ○ | ○ |
| Electrical resistance | ○ | ○ | ○ |

The evaluation methods of the tack-free dryness and the developing properties shown in Table 4 mentioned above are as follows:

Tack-free Dryness:

The tack-free dryness of the surface of the dried coating film was evaluated.

○: Absolute absence of tackiness
Δ: Presence of only slight tackiness
×: Presence of tackiness

Developing Properties:

The developed surface was visually examined by the use of a magnifier.

○: Development was perfect because ink was completely removed during development.
×: Undeveloped portion having at least slight residue was observed in development.

Synthetic Example 6:

Into an autoclave equipped with a thermometer, a device for introduction of nitrogen and alkylene oxide, and a stirrer, 119.4 parts of a cresol novolak resin (manufatured by Showa Highpolymer Co., Ltd., trade name "Shonol CRG951", OH equivalent: 119.4), 1.19 parts of potassium hydroxide, and 119.4 parts of toluene were charged. The air in the system chamber was replaced with nitrogen while stirring the mixture. The temperature of the mixture was then increased by heating and then 63.8 parts of propylene oxide was gradually added dropwise thereto to cause reaction thereof for 16 hours at 125-132°C under pressure of 0-4.8 kg/cm$^2$. Thereafter, the reaction solution was cooled to room temperature. To this reaction solution, 1.56 parts of 89% phosphoric acid was added and mixed therewith to neutralize potassium hydroxide, thereby obtaining a propylene oxide reaction solution of cresol novolak resin having a nonvolatile content of 62.1% and the hydroxyl equivalent of 182.2 g/eq. This means that 1.08 mols of the alkylene oxide was added to one equivalent of the phenolic hydroxyl group on average.

Into a reaction vessel equipped with a stirrer, a thermometer, and an air blowing tube, 293.0 parts of the alkylene oxide reaction solution of cresol novolak resin obtained as above, 43.2 parts of acrylic acid, 11.53 parts of methanesulfonic acid, 0.18 part of methylhydroquinone, and 252.9 parts of toluene were charged and left reacting for 12 hours at 110°C while stirring and blowing air thereinto at a rate of 10 ml/minute. 12.6 parts of water caused by the reaction was distilled out together with toluene as an azeotropic mixture. Thereafter, the reaction solution was cooled to room temperature. The obtained reaction solution was neutralized with 35.35 parts of an aqueous 15% sodium hydroxide solution and washed with water. Thereafter, toluene was distilled out by means of an evaporator while replacing it with 118.1 parts of diethylene glycol monoethyl ether acetate to obtain a novolak type acrylate resin solution.
Next, 332.5 parts of the resultant novolak type acrylate resin solution and 1.22 parts of triphenylphosphine were charged into a reaction vessel equipped with a stirrer, a thermometer and an air blowing tube. 60.8 parts of tetrahydrophthalic anhydride was gradually added to the mixture while stirring it and blowing air thereinto at the rate of 10 ml/minute and left reacting for 6 hours at 95-101°C. The product was cooled and then extracted from the vessel. The curable resin consequently obtained was found to have a nonvolatile content of 70.6% and an acid value of 87.7 mg KOH/g as solids.

Synthetic Example 7:

Into an autoclave equipped with a thermometer, a device for introduction of nitrogen and alkylene oxide, and a stirrer, 98 parts of the polyphenol resin (manufatured by Japan Epoxy Resin Co., Ltd., trade name "EPICURE YL6065", OH equivalent: 98), 0.98 part of potassium hydroxide, and 98 parts of toluene were charged. The air in the system chamber was replaced with nitrogen while stirring the mixture and the temperature of the mixture was increased by heating. Then, 63.8 parts of propylene oxide was gradually added dropwise to the mixture and the resultant mixture was left reacting for 16 hours at 125-132°C under a pressure of 0-4.8 kg/cm$^2$. Thereafter, The reaction solution was cooled to room temperature. To this reaction solution, 1.28 parts of 89% phosphoric acid was added and mixed therewith to neutralize potassium hydroxide. The obtained reaction solution of propylene oxide to the polyphenol resin had a nonvolatile content of 63.8% and the hydroxyl equivalent of 160.7 g/eq. This means that 1.08 mols of the alkylene oxide was added to one equivalent of the phenolic hydroxyl group on average.
251.8 parts of the reaction solution of propylene oxide to the polyphenol resin obtained as above, 43.2 parts of acrylic acid, 11.53 parts of methanesulfonic acid, 0.18 part of methyl hydroquinone, and 217.3 parts of toluene were charged into a reaction vessel equipped with a stirrer, a thermometer, and an air blowing tube and left reacting for 12 hours at 110°C while blowing air thereinto at a rate of 10 ml/min. and stirring the mixture. 12.6 parts of water caused by the reaction was distilled out together with toluene as an azeotropic mixture. Thereafter, the reaction solution was cooled to room temperature. The obtained reaction solution was neutralized with 35.35 parts of an aqueous 15% sodium hydroxide solution and then washed with water. Thereafter, toluene was distilled out by means of an evaporator while replacing it with 113.0 parts of diethylene glycol monoethyl ether acetate to obtain an acrylate resin solution having a nonvolatile content of 63.4%.
Next, 304.5 parts of the resultant acrylate resin solution and 1.22 parts of triphenylphosphine were charged into a reaction vessel equipped with a stirrer, a thermometer, and an air blowing tube. 60.8 parts of tetrahydrophthalic anhydride was gradually added to the mixture while blowing air thereinto at a rate of 10 ml/min. and stirring the mixture, and they were left reacting for 6 hours at 95-105°C. The product was cooled and then extracted from the reaction vessel. The curable resin consequently obtained was found to have a nonvolatile content of 70.5% and an acid value of 93.1 mg KOH/g as solids.

Examples 7-9 and Comparative Example 2:

The flame-retardant, photocurable and thermosetting resin compositions were prepared. by compounding relevant components at proportions (numerical values indicate parts by weight) shown in Table 5 and kneading them with a three-roll mill, respectively. Each of the compositions was applied by the screen printing method using a polyester screen of 100 mesh to the entire surface of a copper plated-throughhole printed circuit board having a prescribed pattern formed in advance thereon to form a coating film of 20-30 μm thickness. The coating film on the board was dried by the use of a hot air drying oven at 80°C for 30 minutes.
Next, the coating film was irradiated with ultraviolet light by using an ultraviolet exposure apparatus (product of ORC Manufacturing Co., Ltd., Model HMW-680GW) through a negative film having a prescribed resist pattern and tightly superposed on the coating film (irradiation dose: 600 mJ/cm$^2$). Then, the coating film was developed for 60 seconds with an aqueous 1% sodium carbonate solution applied by spraying at a pressure of 2.0 kg/cm$^2$ to dissolve out the unexposed portion. Thereafter, the coating film on the board was thermally cured in a hot air drying oven at 150°C for 60 minutes to prepare a test board.
The resultant test board having the cured film was tested for the resistance to soldering heat, acid resistance,

alkali resistance, adhesiveness, PCT resistance, and resistance to electroless gold plating and in accordance with the testing method and the evaluation method described hereinbefore.

Further, a glass plate used in place of the copper plated-throughhole printed circuit board was treated under the same conditions as described above to obtain the water absorption. Furthermore, by using a B pattern of a printed circuit board (thickness: 1.6 mm) specified by IPCT in place of the copper plated-throughhole printed circuit board, a test board was prepared under the same conditions as described above and the electrical resistance was tested.

Further, by using a board specified in the flame retardancy test specification for high-molecular materials, UL94V0, issued by Underwriters Laboratories Inc. (UL), USA in place of the copper plated-throughhole printed circuit board, a test board was prepared under the same conditions as described above and the flame retardancy was tested.

The results of each of the above tests are shown in Table 6.

Table 5

| Components (parts by weight) | | Example | | | Comparative Example 2 |
|---|---|---|---|---|---|
| | | 7 | 8 | 9 | |
| Curable resin | Resin of Synthetic Example 6 | 141.6 | - | - | 141.6 |
| | Resin of Synthetic Example 7 | - | 141.8 | - | - |
| | Resin of Synthetic Example 3 | - | - | 139.3 | - |
| Irgacure 907 *1) | | 15.0 | 15.0 | 15.0 | 15.0 |
| DETX-S *2) | | 1.0 | 1.0 | 1.0 | 1.0 |
| Diethylene glycol monoethyl ether acetate | | 6.0 | 6.0 | 6.0 | 6.0 |
| Phthalocyanine blue | | 1.5 | 1.5 | 1.5 | 1.5 |
| Silicone KS-66 *3) | | 2.0 | 2.0 | 2.0 | 2.0 |
| AEROSIL 380 *4) | | 2.0 | 2.0 | 2.0 | 2.0 |
| Melamine | | 1.5 | 1.5 | 1.5 | 1.5 |
| DPHA *5) | | 15.0 | 15.0 | 15.0 | 15.0 |
| RE306 *6) | | 13.1 | 13.9 | 9.8 | 13.1 |
| Epo-Thoto YDCN 704P *7) | | 16.4 | 17.4 | 12.2 | 32.8 |
| Epo-Thoto YDB-408 *8) | | 58.5 | 62.2 | 43.8 | - |
| CDP *9) | | 20.0 | - | 20.0 | - |
| Antimony pentaoxide | | - | 8.0 | - | - |
| Remarks | | | | | |

*1) Irgacure 907: 2-methyl-1-[4-(methylthio)phenyl]-2-morpholino-aminopropanone-1 (produced by Ciba Specialty Chemicals Inc.)
*2) DETX-S: 2,4-diethylthioxanthone (produced by Nippon Kayaku Co., Ltd.)
*3) Silicone KS-66: Silicone type anti-foaming agent (produced by Shinetsu Silicone Co., Ltd.)
*4) AEROSIL 380: finely pulverized silica (produced by Nippon Aerosil Co., Ltd.)
*5) DPHA: a mixture of dipentaerythritol hexa- and penta-acrylates (produced by Nippon Kayaku Co., Ltd.)
*6) RE306: novolak type epoxy resin (produced by Nippon Kayaku Co., Ltd.)
*7) Epo-Thoto YDCN-704P: novolak type epoxy resin (produced by Thoto Kasei Co., Ltd.)
*8) Epo-Thoto YDB-408: tetrabromobisphenol A type epoxy resin (produced by Thoto Kasei Co., Ltd.)
*9) CDP: cresyl diphenyl phosphate (produced by Daihachi Chemical Industry Co., Ltd.)

Table 6

| Properties Properties | Example | | | Comparative Example 2 |
|---|---|---|---|---|
| | 7 | 8 | 9 | |
| Resistance to soldering heat | ○ | ○ | ○ | ○ |
| Acid resistance | ○ | ○ | ○ | ○ |
| Alkali resistance | ○ | ○ | ○ | ○ |

Table 6 (continued)

| Properties Properties | Example | | | Comparative Example 2 |
|---|---|---|---|---|
| | 7 | 8 | 9 | |
| Adhesiveness | ◎ | ◎ | ◎ | ◎ |
| PCT resistance | ○ | ○ | ○ | ◎ |
| Resistance to electoless gold plating | ○ | ○ | ○ | ◎ |
| Water absorption (%) | 1.2 | 1.2 | 1.3 | 1.0 |
| Electrical resistance | ○ | ○ | ○ | ○ |
| Flame retardancy | ○ | ○ | ○ | × |

The evaluation method of the flame retardancy shown in Table 6 mentioned above is as follows:

Flame Retardancy:

The flame retardancy of the test board was evaluated on the following criterion by the use of the apparatus specified in the UL flame retardancy test specification for high-molecular materials, UL94 and in accordance with the method specified therein.

○: The test board exhibited the flame retardancy equivalent to V-0.
×: The test board did not exhibit the flame retardancy equivalent to V-0.

Industrial Applicability

As described above, since the curable resin of the present invention has an unsaturated group and a carboxyl group added to the terminals of its side chains, it exhibits excellent reactivity. Further, since the curable resin contains a hydrophilic and alcoholic hydroxyl group which exhibits low reactivity in a small amount or contains no such group, it allows the formation of a cured product having well-balanced heat resistance and PCT resistance at a high level and excelling in various properties such as adhesiveness to a substrate, hardness, resistance to chemicals, and resistance to moisture absorption. Therefore, a curable resin composition comprising this curable resin together with a photopolymerization initiator, a photosensitive (meth)acrylate compound, an epoxy compound, a diluent solvent, etc. exhibits excellent alkali-developing properties and gives a cured product excelling in such properties as resistance to soldering heat, PCT resistance, adhesiveness, resistance to chemicals, resistance to electroless gold plating, electrical insulating properties, and resistance to moisture absorption required of a solder resist or the like which is capable of coping with the high densification and surface mounting technology of the printed circuit board.

Accordingly, the photocurable and thermosetting resin composition containing such a curable resin as a curing component is not only usable as an ultraviolet-curable type printing ink which is cured by the use of the actinic energy rays or other usage but also useful as a solder resist to be used in the manufacture of a printed circuit board, an interlaminar insulating layer of a multi-layer circuit board, a permanent mask to be used in the manufacture of a tape carrier package, and further a resist to be used in the manufacture of a color filter and the like, because its cured film will not exfoliate from a substrate even when exposed to the conditions of high temperature and high humidity and also excels in various properties as mentioned above. Further, by the use of the photocurable and thermosetting resin composition excelling in flame retardancy, the highly reliable mounting of the electronic devices can be expected.

## Claims

1. A curable resin obtained by reacting an unsaturated group-containing monocarboxylic acid (d) with a reaction product (c) of a compound having three or more phenolic hydroxyl groups in its molecule (a) and an alkylene oxide (b) and further reacting a polybasic acid anhydride (f) with the resultant reaction product (e).

2. The curable resin according to claim 1, **characterized in that** said compound having three or more phenolic hydroxyl groups in its molecule (a) is a condensation product of a phenolic compound represented by the following general formula (III) and an aromatic aldehyde compound having a phenolic hydroxyl group.

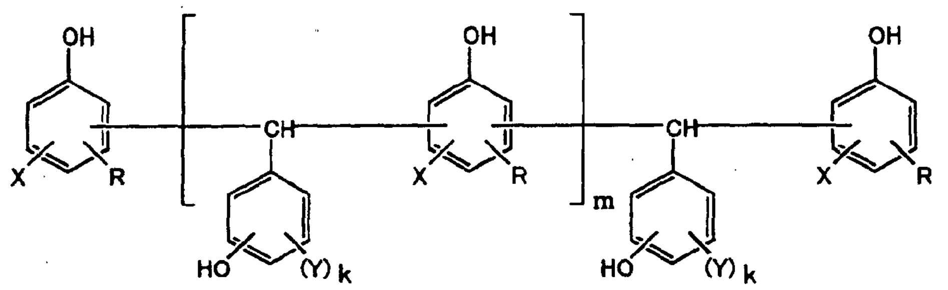

··· (III)

wherein R represents a hydrogen atom or an alkyl group having 1 to 18 carbon atoms, X represents a hydrogen atom or a halogen atom, Y represents an alkyl group or an alkoxy group each having 1 to 18 carbon atoms, k is an integer of 0, 1, or 2, and m is an integer of 0 or more.

**3.** The curable resin according to claim 1 or 2, **characterized in that** said unsaturated group-containing monocarboxylic acid (d) is acrylic acid and/or methacrylic acid.

**4.** The curable resin according to any one of claims 1 to 3, **characterized in that** said polybasic acid anhydride (f) is an alicyclic dibasic acid anhydride.

**5.** A curable resin having the groups represented by the following formulas (I) and (II) in its side chains.

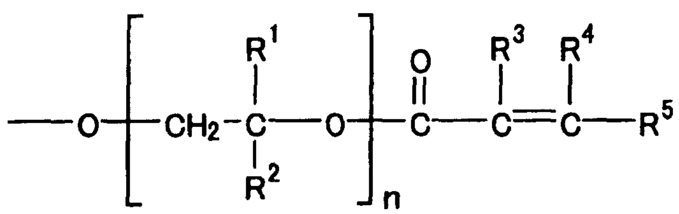

··· (I)

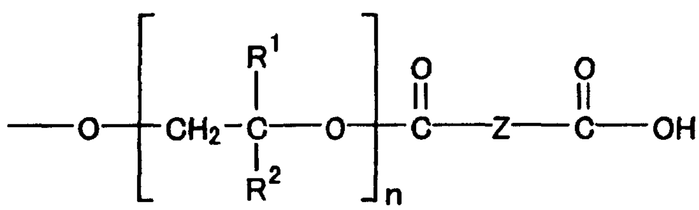

··· (II)

wherein $R^1$ and $R^2$ independently represent a hydrogen atom, a methyl group, or an ethyl group, $R^3$, $R^4$, and $R^5$ independently represent a hydrogen atom, an alkyl group having 1 to 6 carbon atoms, an aryl group, an aralkyl group, a cyano group, a fluorine atom, or a furyl group, Z represents a polybasic acid anhydride residue, and n is a numerical value of 0.5 to 10.

**6.** A curable resin composition comprising said curable resin set forth in any one of claims 1 to 5.

**7.** A photocurable and thermosetting resin composition, **characterized by** comprising (A) a curable resin obtained by reacting an unsaturated group-containing monocarboxylic acid (d) with a reaction product (c) of a compound having three or more phenolic hydroxyl groups in its molecule (a) and an alkylene oxide (b) and further reacting a polybasic acid anhydride (f) with the resultant reaction product (e), (B) a photopolymerization initiator, (C) a photosensitive (meth) acrylate compound, (D) an epoxy compound, and (E) a diluent solvent.

**8.** A photocurable and thermosetting resin composition, **characterized by** comprising (A) a curable resin having the groups represented by the following formulas (I) and (II) in its side chains, (B) a photopolymerization initiator, (C) a photosensitive (meth)acrylate compound, (D) an epoxy compound, and (E) a diluent solvent.

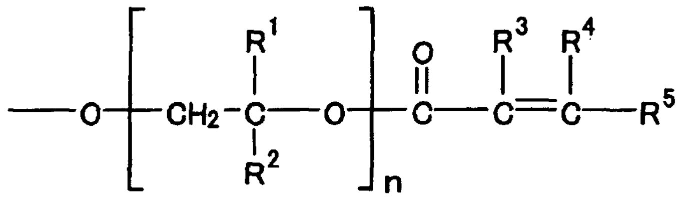 ··· (I)

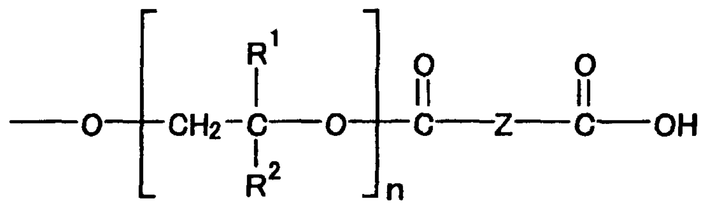 ··· (II)

wherein $R^1$ and $R^2$ independently represent a hydrogen atom, a methyl group, or an ethyl group, $R^3$, $R^4$, and $R^5$ independently represent a hydrogen atom, an alkyl group having 1 to 6 carbon atoms, an aryl group, an aralkyl group, a cyano group, a fluorine atom, or a furyl group, Z represents a polybasic acid anhydride residue, and n is a numerical value of 0.5 to 10.

**9.** A photocurable and thermosetting resin composition, **characterized by** comprising (A) a curable resin obtained by reacting an unsaturated group-containing monocarboxylic acid (d) with a reaction product (c) of a compound having three or more phenolic hydroxyl groups in its molecule (a) and an alkylene oxide (b) and further reacting a polybasic acid anhydride (f) with the resultant reaction product (e), (B) a photopolymerization initiator, (C) a photosensitive (meth)acrylate compound, (D) an epoxy compound, (E) a diluent solvent, and (F) a curable resin which has a carboxyl group and an unsaturated group in its molecule and which is in the state of solid at room temperature.

**10.** A photocurable and thermosetting resin composition, **characterized by** comprising (A) a curable resin having the groups represented by the following formulas (I) and (II) in its side chains, (B) a photopolymerization initiator, (C) a photosensitive (meth)acrylate compound, (D) an epoxy compound, (E) a diluent solvent, and (F) a curable res in which has a carboxyl group and an unsaturated group in its molecule and which is in the state of solid at room temperature.

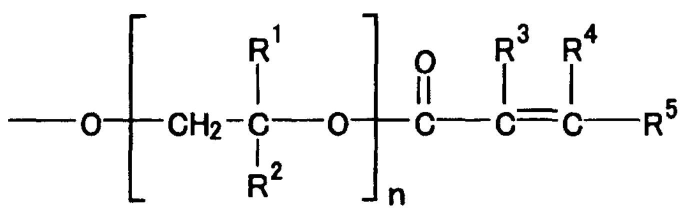 ··· (I)

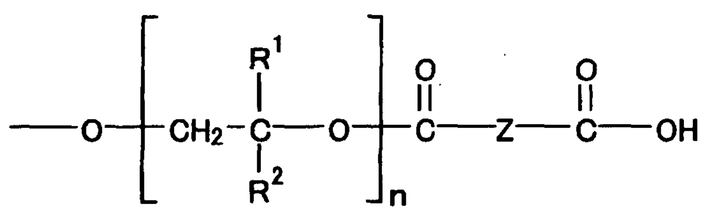 ··· (II)

wherein $R^1$ and $R^2$ independently represent a hydrogen atom, a methyl group, or an ethyl group, $R^3$, $R^4$, and $R^5$ independently represent a hydrogen atom, an alkyl group having 1 to 6 carbon atoms, an aryl group, an aralkyl

group, a cyano group, a fluorine atom, or a furyl group, Z represents a polybasic acid anhydride residue, and n is a numerical value of 0.5 to 10.

**11.** The photocurable and thermosetting resin composition according to any one of claims 7 to 10, **characterized by** further comprising (G) a curing catalyst.

**12.** The photocurable and thermosetting resin composition according to any one of claims 7 to 11, **characterized by** further comprising (H) a flame-retardant.

**13.** The photocurable and thermosetting resin composition according to claim 12, **characterized in that** said flame-retardant (H) is at least one member selected from the group consisting of a halogenated epoxy resin, a halogenated aromatic compound, a halogenated alicyclic compound, a phosphate-based flame-retardant, and an antimony oxide-based flame-retardant.

Fig. 1

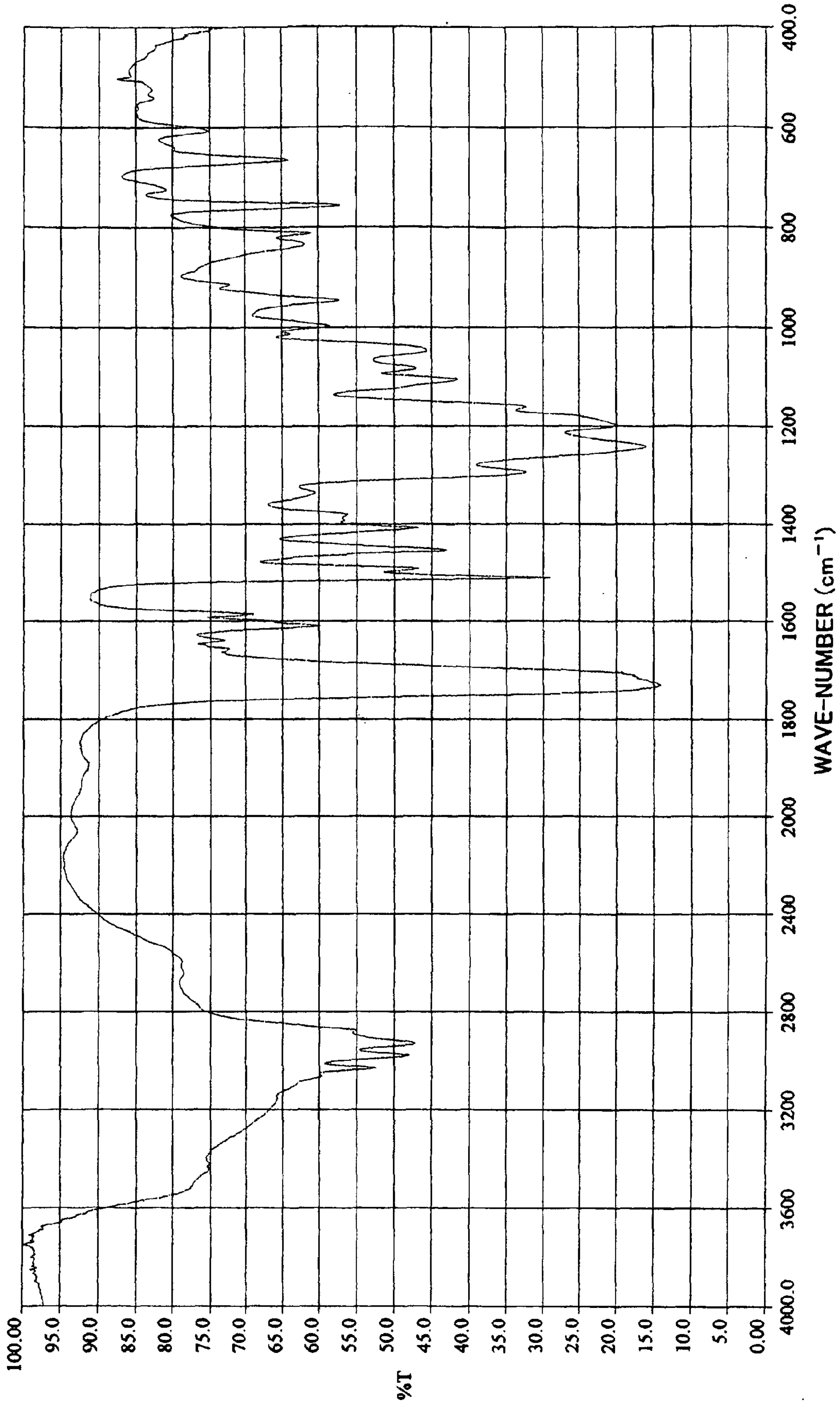
%T
100.00
95.0
90.0
85.0
80.0
75.0
70.0
65.0
60.0
55.0
50.0
45.0
40.0
35.0
30.0
25.0
20.0
15.0
10.0
5.0
0.00
4000.0
3600
3200
2800
2400
2000
1800
1600
1400
1200
1000
800
600
400.0
WAVE-NUMBER (cm⁻¹)

**INTERNATIONAL SEARCH REPORT**

International application No.
PCT/JP03/02930

A. CLASSIFICATION OF SUBJECT MATTER
Int.Cl[7] C08G8/28, C08F290/02, C08F8/00, C08G59/16

According to International Patent Classification (IPC) or to both national classification and IPC

B. FIELDS SEARCHED

Minimum documentation searched (classification system followed by classification symbols)
Int.Cl[7] C08G8/28-8/36, C08F290/02-290/06, C08F8/00, C08G59/16

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2003 |
| Kokai Jitsuyo Shinan Koho | 1971-2003 | Toroku Jitsuyo Shinan Koho | 1994-2003 |

Electronic data base consulted during the international search (name of data base and, where practicable, search terms used)
CA(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2-6517 A (Toa Gosei Kagaku Kogyo Kabushiki Kaisha),<br>10 January, 1990 (10.01.90),<br>Full text<br>(Family: none) | 1,3-6<br>2,7-13 |
| P,X<br>P,A | WO 02/24774 A1 (Taiyo Ink Seizo Kabushiki Kaisha),<br>28 March, 2002 (28.03.02),<br>Full text<br>(Family: none) | 1,3-8,11-13<br>2,9,10 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 June, 2003 (16.06.03) | 01 July, 2003 (01.07.03) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP03/02930

C (Continuation). DOCUMENTS CONSIDERED TO BE RELEVANT

| Category* | Citation of document, with indication, where appropriate, of the relevant passages | Relevant to claim No. |
|---|---|---|
| A | JP 61-243869 A (Taiyo Ink Seizo Kabushiki Kaisha), 30 October, 1986 (30.10.86), Full text & GB 8608996 A & DE 3613107 A1 & FR 2580828 A1 | 1-13 |
| A | JP 11-288091 A (Taiyo Ink Seizo Kabushiki Kaisha), 19 October, 1999 (19.10.99), Claims 1, 3, 4; Par. Nos. [0008] to [0030] (Family: none) | 1-13 |
| A | JP 58-11521 A (Maruzen Sekiyu Kabushiki Kaisha), 22 January, 1983 (22.01.83), Full text (Family: none) | 1-13 |
| A | JP 63-117053 A (Hitachi, Ltd.), 21 May, 1988 (21.05.88), Full text (Family: none) | 1-13 |

Form PCT/ISA/210 (continuation of second sheet) (July 1998)

**INTERNATIONAL SEARCH REPORT**

International application No.
PCT/JP03/02930

**Box I Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box II Observations where unity of invention is lacking (Continuation of item 3 of first sheet)**

This International Searching Authority found multiple inventions in this international application, as follows:

As a result of search, the "curable resin" set forth in claim 1 is revealed to be not novel as disclosed in documents cited in Box C. Accordingly, there is neither the same nor corresponding matter considered as a "special technical feature" within the meaning of PCT Rule 13.2 between claims 1-4 and claims 5-13.

Thus, claims 1-13 do not comply with the requirement of unity of invention.

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** ☐ The additional search fees were accompanied by the applicant's protest.
☐ No protest accompanied the payment of additional search fees.

Form PCT/ISA/210 (continuation of first sheet (1)) (July 1998)